(19) **Europäisches Patentamt / European Patent Office / Office européen des brevets**

(11) **EP 4 364 290 B1**

(12) **EUROPEAN PATENT SPECIFICATION**

(45) Date of publication and mention of the grant of the patent:
**28.01.2026  Bulletin 2026/05**

(21) Application number: **21947624.9**

(22) Date of filing: **01.07.2021**

(51) International Patent Classification (IPC):
*H03F 1/02* $^{(2006.01)}$   *H03F 3/195* $^{(2006.01)}$
*H03F 3/24* $^{(2006.01)}$   *H03F 3/68* $^{(2006.01)}$
*H03F 3/72* $^{(2006.01)}$   *H03F 1/42* $^{(2006.01)}$
*H03F 3/60* $^{(2006.01)}$

(52) Cooperative Patent Classification (CPC):
**H03F 3/195; H03F 1/0288; H03F 1/42; H03F 3/245; H03F 3/602; H03F 3/68; H03F 3/72;** H01P 5/12; H03F 2200/111; H03F 2200/192; H03F 2200/198; H03F 2200/204; H03F 2200/429; H03F 2200/451

(86) International application number:
**PCT/CN2021/103930**

(87) International publication number:
**WO 2023/272671 (05.01.2023 Gazette 2023/01)**

(54) **MULTIBAND DOHERTY POWER AMPLIFIER ARRANGEMENTS WITH HYBRID COMBINERS**

MEHRBANDIGE DOHERTY-LEISTUNGSVERSTÄRKERANORDNUNGEN MIT HYBRIDKOMBINIERERN

AGENCEMENTS D'AMPLIFICATEURS DE PUISSANCE DOHERTY MULTIBANDE AVEC DES COMBINATEURS HYBRIDES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**08.05.2024  Bulletin 2024/19**

(73) Proprietor: **Telefonaktiebolaget LM Ericsson (publ)**
**164 83 Stockholm (SE)**

(72) Inventors:
• **HOU, Rui**
**187 60 Taeby (SE)**
• **JIN, Yonghai**
**Beijing 100126 (CN)**

(74) Representative: **Ericsson Patent Development**
**Torshamnsgatan 21-23**
**164 80 Stockholm (SE)**

(56) References cited:
CN-A- 102 986 134    CN-A- 108 134 580
US-A1- 2013 099 866    US-A1- 2015 091 653
US-A1- 2018 091 100    US-B1- 9 634 615

• CHEN SHICHANG; WANG WEIWEI; ZHAO PENG; XU KUIWEN; CAI JIALIN; WANG GAOFENG: "Wide-band/Multi-band Doherty and outphasing power amplifier designs", 2019 EUROPEAN MICROWAVE CONFERENCE IN CENTRAL EUROPE (EUMCE), EUMCE, 13 May 2019 (2019-05-13), pages 204 - 207, XP033634591

**Description**

TECHNICAL FIELD

Embodiments herein relate to power amplifier arrangements. In particular, they relate to multiband Doherty power amplifiers with hybrid combiners, an electronic apparatus comprising one or more multiband Doherty power amplifiers.

BACKGROUND

With the rapid development of communication technologies, mobile communication systems have to accommodate many standards simultaneously. This requirement stimulates the demand for multiband power amplifiers (PA). In the conventional multiband PA solution, several single band PAs are paralleled, and the outputs of each PA are added together using passive combiners or multiplexers. These architectures will lead to a significant power loss.

Although a classic Doherty PA meets the efficiency and linearity requirements, it is an inherent narrow-band solution, because of the use of frequency limited quarter wave transmission lines. Therefore, it may not satisfy the broadband requirements with emerging wireless standards. A clear source of limited bandwidth in the Doherty PA is the impedance inverter which connects the carrier and peaking amplifier together.

To support multiband requirements, broadband high efficiency PA technology is developed recently. However the efficiency of the broadband PA solution is still lower than the narrow band Doherty PA (DPA). That is because the bandwidth and efficiency are trade off performances in PA design. Multiband DPA disclosed in JingZhou Pang et. al, "Novel design of highly-efficiency concurrent dual-band GaN Doherty power amplifier using direct-matching impedance transformers", 2016 IEEE MTT-S International Microwave Symposium (IMS), has the potential to achieve comparative performance with the conventional narrow band DPAs. However, when it works in concurrent dual band mode, the efficiency will be dropped comparing to single band mode due to a lots of intermodulation signal power coming out when different band signals input into one PA.

One alternative solution is proposed in EP2713505. Two narrow band main PAs with one wideband auxiliary PA combined to support multiband application. In practical radio units with PA used for cellular base stations, the loading of a multiband power amplifier is often not a wideband load impedance, but many narrow-band band-pass filters. This means for N operating frequency bands, the PA loading are N bandpass filters. For the prior art solution in EP2713505, the output from the PA is a wideband signal. It requires a 1-to-N multiplexer to divide the wideband output signal from the PA to feed the N narrow-band filters. This 1-to-N multiplexer causes extra insertion loss, volume, and weight.

Further examples of multiband power amplifiers are provided by documents US2013/099866 A1 and US 9634615 B1.

SUMMARY

It is therefore an object of embodiments herein to provide a high efficiency multiband power amplifier.

According to one aspect of embodiments herein, the object is achieved by a power amplifier arrangement for amplifying signals with multiple frequency bands. The power amplifier arrangement comprises multiple inputs and multiple outputs, each input is for receiving an input signal within one frequency band of the multiple frequency bands, each output is for providing an output signal within one frequency band of the multiple frequency bands.

The power amplifier arrangement further comprises multiple main amplifiers, each of the multiple main amplifiers is configured as a narrow band amplifier for amplifying a signal within one frequency band of the multiple frequency bands. Inputs of the multiple main amplifiers are coupled to the respective inputs of the power amplifier arrangement for receiving the input signals within the respective frequency bands. Outputs of the multiple main amplifiers are coupled to the respective outputs of the power amplifier arrangement for providing the output signals within the respective frequency bands.

The power amplifier arrangement further comprises multiple auxiliary amplifiers. Each auxiliary amplifier is configured as a wideband amplifier for amplifying signals within at least two frequency bands of the multiple frequency bands.

The power amplifier arrangement further comprises one or more input hybrid couplers at the inputs and one or more output hybrid couplers at the outputs of the power amplifier arrangement.

An input of an auxiliary amplifier is coupled to one of the multiple inputs of the power amplifier arrangement through one or more input hybrid couplers. An output of an auxiliary amplifier is coupled to one of the multiple outputs of the power amplifier arrangement through one or more output hybrid couplers such that an output signal from that auxiliary amplifier is split into different output signals within different frequency bands, and the signals within the same frequency band output from the main amplifier and auxiliary amplifier are combined in-phase at the output of the power amplifier arrangement for providing the output signal within that frequency band.

In other words, the power amplifier arrangement according to the embodiments herein comprises multiple narrow band main PAs and multiple wideband auxiliary PAs with multiple narrow band output ports. For each output port, narrow band main PA works at high efficiency status as conventional narrow band DPAs, wideband auxiliary PAs are sharing for signals with different bands which can support multiband power pooling application. The power pooling means that radio frequency signal power may be dynamically allocated to different frequency bands according to actual communication traffic needs. For example, two frequency bands may be covered by two stand-alone PAs, each with 10W power capacity. Then the maximum power per band cannot exceed 10W. Alternatively, a single 20W dual-band PA may be used to cover these two bands, then the power configuration between the two bands may be more flexible, e.g. 10W+10W or 15W+5W according to real-time communication traffic needs. With hybrid combiners, it's easy to divide the signals with different bands for different bands output ports.

According to the embodiments herein, the power amplifier arrangement has N multiple narrow band outputs. The output signal power from the N narrow band main PAs and the wideband auxiliary PAs are combined at N different combining points, in contrast to the single power combining point in prior art EP2713505. This removes the need of a 1-to-N multiplexer at the PA output for feeding N narrow-band filters, therefore reduces the insertion loss, volume, and weight of the radio units with PAs.

Therefore, the power amplifier arrangement according to the embodiments herein is a multiband power amplifier with high efficiency.

BRIEF DESCRIPTION OF THE DRAWINGS

Examples of embodiments herein are described in more detail with reference to attached drawings in which:

Figure 1     (a) and (b) are general structures illustrating a power amplifier arrangement according to embodiments herein;

Figure 2     (a) and (b) are simplified basic structures of a power amplifier arrangement according to embodiments herein;

Figure 3     (a) is a simplified basic structure of a power amplifier arrangement with isolation circuits according to embodiments herein, (b)-(d) are example isolation circuits;

Figure 4     (a) is a simplified basic structure of a power amplifier arrangement with a signal splitter, (b)-(e) are examples of signal splitters;

Figure 5     illustrates examples of split input signals for the main and auxiliary amplifiers according to embodiments herein;

Figure 6     illustrates other examples of split input signals for the main and auxiliary amplifiers according to embodiments herein;

Figure 7 (a)     is a principle structure of a power amplifier arrangement to show that the auxiliary amplifiers operate with sub-Doherty function combining, (b) is a general structure of a power amplifier arrangement, where the auxiliary amplifiers may have different bias condition for a sub-Doherty function combining;

Figure 8     is a simplified basic structure of a power amplifier arrangement with switches for dynamic TDD application according to embodiments herein;

Figure 9     shows an example implementation of leakage cancellation for dynamic TDD application for the power amplifier arrangement according to embodiments herein;

Figure 10     illustrates an example of 4-band power amplifier arrangement according to embodiments herein;

Figure 11     illustrates an example of dual-band power amplifier arrangement according to embodiments herein;

Figure 12     illustrates a simulation circuit for the power amplifier arrangement according to embodiments herein;

Figure 13     is a diagram illustrating simulation results for an ideal FET power amplifier;

Figures 14-19     are simulation results for the power amplifier arrangement according to embodiments herein; and

Figure 20     is a block diagram illustrating an electronic circuit or apparatus in which the power amplifier arrangement according to embodiments herein may be implemented.

DETAILED DESCRIPTION

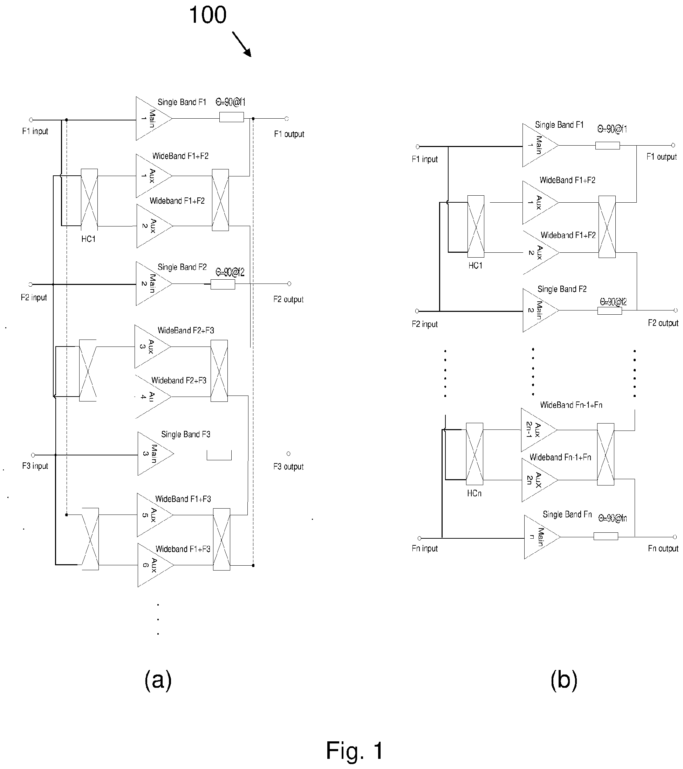

**Figures 1 (a)** and **(b)** show general structures for a power amplifier arrangement **100** according to embodiments herein for amplifying signals with multiple frequency bands F1, F2, F3, ... Fn. The power amplifier arrangement 100 comprises multiple inputs **F1 input, F2 input,** ... **Fn input,** and multiple outputs **F1 output, F2 output,** ... **Fn output.**

Each input is for receiving an input signal within one frequency band of the multiple frequency bands F1, F2, F3... Fn.

Each output is for providing an output signal within one frequency band of the multiple frequency bands F1, F2, F3... Fn.

The power amplifier arrangement 100 further comprises multiple main amplifiers **Main 1, Main 2, ...Main n.** Each of the multiple main amplifiers is configured as a narrow band amplifier for amplifying a signal within one frequency band of the multiple frequency bands F1, F2, F3... Fn. For example, the first main amplifier Main 1 is for amplifying the signal within the first frequency band F1.

Inputs of the multiple main amplifiers are coupled to the respective inputs of the power amplifier arrangement 100 for receiving the input signals within the respective frequency bands and outputs of the multiple main amplifiers are coupled to the respective outputs of the power amplifier arrangement 100 for providing the output signals within the respective frequency bands. For example, the input of the first main amplifier Main 1 is coupled to the first input F1 input of the power amplifier arrangement 100 to receive the signal within the first frequency band F1, the output of the first main amplifier Main 1 is coupled to the first output F1 output of the power amplifier arrangement 100.

The power amplifier arrangement 100 further comprises multiple auxiliary amplifiers **Aux 1, Aux 2..., Aux 2n-1, Aux 2n** Each auxiliary amplifier is configured as a wideband amplifier for amplifying signals within at least two frequency bands F1+F2, ... F2+F3... of the multiple frequency bands F1, F2, F3,... Fn. For example, the first and second auxiliary amplifiers Aux 1, 2 are for amplifying the signal within the first and second frequency bands F1+F2.

The power amplifier arrangement 100 further comprises one or more hybrid couplers at the inputs and one or more hybrid couplers at the outputs of the power amplifier arrangement 100.

An input of an auxiliary amplifier is coupled to one of the multiple inputs of the power amplifier arrangement 100 through one or more hybrid couplers to receive the input signals within at least two frequency bands.

For example, the first input signal within the first frequency band F1 is input to the first and second auxiliary amplifiers Aux 1, Aux 2 through a first hybrid coupler **HC1.**

An output of an auxiliary amplifier is coupled to one of the multiple outputs of the power amplifier arrangement 100 through one or more hybrid couplers such that an output signal from that auxiliary amplifier is split into different output signals within different frequency bands, and the signals within the same frequency band output from the main amplifier and auxiliary amplifier are combined in-phase at the output of the power amplifier arrangement for providing the output signal within that frequency band.

As shown in Figure 1, the outputs of the multiple main amplifiers are coupled to the respective outputs of the power amplifier arrangement 100 through respective transmission lines for impedance matching and phase compensation.

A two-way DPA comprises of at least two PA branches, namely a class AB biased main and a class-C biased auxiliary branch. The main amplifier is always in the "on" state. Whereas, the auxiliary amplifier is in the "on" state only when the input-power is large, this provides additional power in the high-power region. Therefore, in operation, the auxiliary PA modulates the effective load impedance of the main PA in a specific pattern, hereafter referred to as Doherty load modulation, such that total efficiency is improved also at the average or back-off power level.

Two main amplifiers and two auxiliary amplifiers in between these two main amplifiers in the power amplifier arrangement 100 may form a branch of two-way Doherty power amplifier and operates in the similar way as the two-way Doherty power amplifier to achieve high efficiency over a wide output power range. Each branch of two-way Doherty power amplifier may operate as a dual-band power amplifier.

Therefore, the power amplifier arrangement 100 is a multiband Doherty power amplifier (DPA). Each of the multiple main amplifiers may be configured to amplify an input signal with a full power range and each of the multiple auxiliary amplifiers may be configured to amplify the input signal with a power range above a threshold.

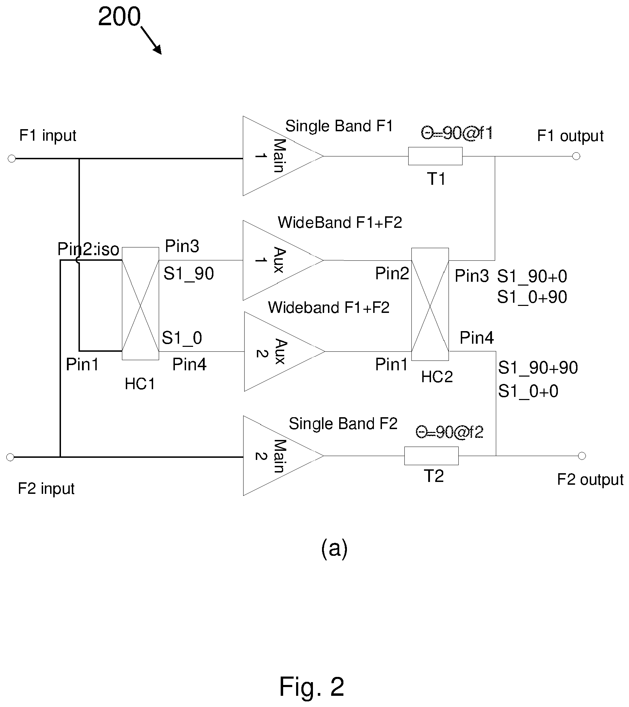

To illustrate the function and operation of the power amplifier arrangement 100 according to embodiments herein, a schematic of a dual-band power amplifier arrangement **200,** i.e. a branch of two-way Doherty power amplifier from the power amplifier arrangement 100, is shown in **Figure 2 (a).**

The power amplifier arrangement 200 comprises:

> a first input **F1 input** for receiving a first input signal within a first frequency band F1;
> a first output **F1 output** for providing a first output signal within the first frequency band F1;
> a second input **F2 input** for receiving a second input signal within a second frequency band F2; and
> a second output **F2 output** for providing a second output signal within the second frequency band F2.

The power amplifier arrangement 200 further comprises:

> a first main amplifier **Main 1,** an input of the first main amplifier is coupled to the first input F1 input of the power amplifier arrangement 200 and an output of the first main amplifier is coupled to the first output F1 output of the power amplifier arrangement 200 through a first transmission line **T1,** and the first main amplifier is configured as a narrow band amplifier to amplify the first input signal within the first frequency band F1 with a full power range; and

a second main amplifier **Main 2,** an input of the second main amplifier is coupled to the second input F2 input of the power amplifier arrangement 200 and an output of the second main amplifier is coupled to the second output F2 output of the power amplifier arrangement 200 through a second transmission line **T2,** and the second main amplifier is configured as a narrowband amplifier to amplify the second input signal within the second frequency band F2 with a full power range.

The power amplifier arrangement 200 further comprises:

a first auxiliary amplifier **Aux 1** configured as a wideband amplifier to amplify the first and second input signals within the first and second frequency bands F1, F2, with a power range above a threshold; and
a second auxiliary amplifier **Aux 2** configured as a wideband amplifier to amplify the first and second input signals within the first and second frequency bands F1, F2, with a power range above a threshold.

The power amplifier arrangement 200 further comprises a first hybrid coupler **HC1** and a second hybrid coupler **HC2.** Each hybrid coupler has four terminals or pins **Pin1, Pin2, Pin3, Pin4.**

Inputs of the auxiliary amplifiers are coupled to the inputs of the power amplifier arrangement 200 through the first hybrid coupler HC1, outputs of the auxiliary amplifiers are coupled to the outputs of the power amplifier arrangement 200 through the second hybrid coupler HC2, e.g. in the following way:
The first terminal Pin1 of the first hybrid coupler HC1 is coupled to the first input F1 input of the power amplifier arrangement 200.

The second terminal Pin2 of the first hybrid coupler HC1 is coupled to the second input F2 input of the power amplifier arrangement 200.

The third terminal Pin3 of the first hybrid coupler HC1 is coupled to an input of the first auxiliary amplifier Aux 1.

The fourth terminal Pin4 of the first hybrid coupler HC1 is coupled to an input of the second auxiliary amplifier Aux 2.

The first terminal Pin1 of the second hybrid coupler HC2 is coupled to an output of the second auxiliary amplifier Aux 2.

The second terminal Pin2 of the second hybrid coupler HC2 is coupled to an output of the first auxiliary amplifier Aux 1.

The third terminal Pin3 of the second hybrid coupler HC2 is coupled to the first output F1 output of the power amplifier arrangement 200.

The fourth terminal Pin4 of the second hybrid coupler HC2 is coupled to the second output F2 output of the power amplifier arrangement 200.

**Table 1** shows the pin configurations for a hybrid coupler. Each pin may be chosen as an input or output terminal. Once a pin is chosen as the input terminal for a signal, the outputs for the signal and the phase relations from the input to the outputs for the signal are fixed, as shown in Table 1.

Table 1

| Pin 1 | Pin 2 | Pin 3 | Pin 4 |
|---|---|---|---|
| input | isolation | $\Delta 90^0$ | $\Delta 0^0$ |
| isolation | input | $\Delta 0^0$ | $\Delta 90^0$ |
| $\Delta 90^0$ | $\Delta 0^0$ | input | isolation |
| $\Delta 0^0$ | $\Delta 90^0$ | isolation | input |

For example, if Pin1 is chosen as an input terminal for the first signal, then Pin2 is an isolation terminal for the first signal, i.e. the first signal can't come out from Pin2, Pin3 is an output terminal for the first signal with 90 degree phase change, and Pin4 is an output terminal for the first signal with 0 degree phase change.

For another example, if Pin2 is chosen as an input terminal for the second signal, then Pin1 is an isolation terminal for the second signal, i.e. the second signal can't come out from Pin1, Pin3 is an output terminal for the second signal with 0 degree phase change, and Pin4 is an output terminal for the second signal with 90 degree phase change.

With these pin configurations in mind, the operation of the power amplifier arrangement 200 will be described in detail with reference to Figure 2 (a), where the phase relation for the first signal is noted at each terminal of the first and second hybrid couplers.

During operation, the first input signal within the first frequency band F1 is input to the first terminal Pin1 of the first hybrid coupler HC1. The first input signal is split to two signals by the first hybrid coupler HC1, one is output at the third terminal Pin3 with 90 degrees phase change, noted with **S1_90,** and one is output at the fourth terminal Pin4 with 0 degrees phase change, noted with **S1_0.**

The signal with 90 degrees phase change, S1_90, is input to the first auxiliary amplifier Aux 1 to get amplified. The amplified signal with 90 degrees phase change is input to the second terminal Pin2 of the second hybrid coupler HC2 and split to two signals by the second hybrid coupler HC2. One is output at the third terminal Pin3 with 0 degrees phase change, noted with **S1_90+0,** and one is output at the fourth terminal Pin4 with 90 degrees phase change, noted with **S1_90+90.**

The signal with 0 degrees phase change, S_0, is input to the second auxiliary amplifier Aux 2 to get amplified. The amplified signal with 0 degrees phase change is input to the first terminal Pin1 of the second hybrid coupler HC2 and split to two signals by the second hybrid coupler HC2. One is output at the third terminal Pin3 with 90 degrees phase change, noted with **S1_0+90,** and one is output at the fourth terminal Pin4 with 0 degrees phase change, noted with **S1_0+0.**

Finally, signals S1_0+90 and S1_90+0 are combined in phase at Pin3 of HC2 and signals S1_0+0 and S1_90+90 are cancelled at Pin4 of HC2 due to opposite phase. That means if a signal input from Pin1 of HC1, it will finally output from Pin3 of HC2. Similarly, if a signal input from Pin2 of HC1, it will finally output from Pin4 of HC2.

Therefore, the amplified signals from both the first and second auxiliary amplifiers are input to the second hybrid coupler HC2 and after being split by the second hybrid coupler HC2 with different phase change, both the amplified signals output at the third terminal Pin3 of the second hybrid coupler HC2 have a phase change of **90** degrees in total compared to the first input signal. Both the amplified signals output at the fourth terminal Pin4 of the second hybrid coupler HC2 have a phase change of **0 or 180** degrees in total compared to the first input signal.

The output signals from the third terminal Pin3 of the second hybrid coupler HC2 are combined with the amplified signal from the first main amplifier Main 1 through the first transmission line T1 with 90 degrees phase change. That is the signals within the first frequency band F1 output from the first main amplifier, the first and second auxiliary amplifiers are combined in-phase at the first output of the power amplifier arrangement 200 for providing the output signal within the first frequency band.

The similar operation applies for the second input signal within the second frequency band F2. The second input signal is input to the second terminal Pin2 of the first hybrid coupler HC1 and split to two signals with 0 and 90 degrees phase change and input to the first and second auxiliary amplifiers respectively. The amplified signals from both the first and second auxiliary amplifiers are input to the second hybrid coupler HC2 and after being split by the second hybrid coupler HC2 with different phase change, both the amplified signals output at the fourth terminal Pin4 of the second hybrid coupler HC2 have a phase change of **90** degrees in total compared to the second input signal. Both the amplified signals output at the third terminal Pin3 of the second hybrid coupler HC2 have a phase change of **0 or 180** degrees in total compared to the second input signal.

The output signals from the fourth terminal Pin4 of the second hybrid coupler HC2 are combined with the amplified signal from the second main amplifier Main 2 through the second transmission line T2 with 90 degrees phase change. That is the signals within the second frequency band F2 output from the second main amplifier, the first and second auxiliary amplifiers are combined in-phase at the second output of the power amplifier arrangement 200 for providing the output signal within the second frequency band F2.

Notice that, there is no output signal within the first frequency band F1 from the fourth terminal Pin4 of the second hybrid coupler HC2 in ideal case. As seen from Figure 2 (a), two amplified signals within the first frequency band F1 come to Pin4 with opposite phase 0/180 and will be cancelled each other if the signal amplitude is same. The same for the third terminal Pin3 of the second hybrid coupler HC2, there is no output signal within the second frequency band F2 from the third terminal Pin3 of the second hybrid coupler HC2.

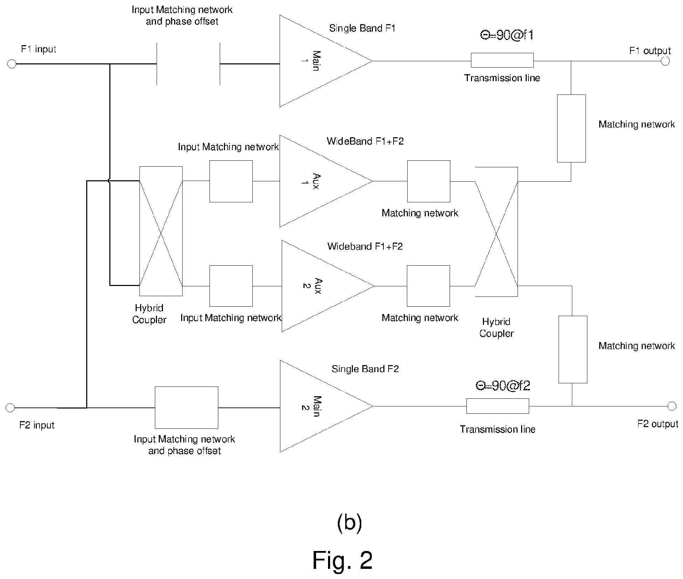

The 90 degrees transmission lines T1 and T2 shown in Figure 2 are only exemplary in an ideal situation, for the functionality of an impedance inverter. The notation θ = 90@f1, θ = 90@f2 in Figure 2 on the transmission lines means a quarter wavelength transmission line for frequency F1 or F2, i.e. a signal with frequency F1 or F2 can go through this transmission line with phase change 90 degrees. It's well known for the people skilled in the art that in practice, due to parasitic effects, transmission lines of other lengths will be used to achieve the impedance inversion function.

Figure 2 (a) is only a basic principle structure of a dual-band power amplifier. In practical applications, matching networks or phase offset networks are always needed at the input and output of each auxiliary amplifier, between the outputs of a hybrid coupler and the outputs of the power amplifier arrangement, at the input of each main amplifier etc. to compensate the phase differences between the main and auxiliary amplifiers for the input signals to the input hybrid coupler HC1 and the output signals from the output hybrid coupler HC2, as shown in **Figure 2 (b).**

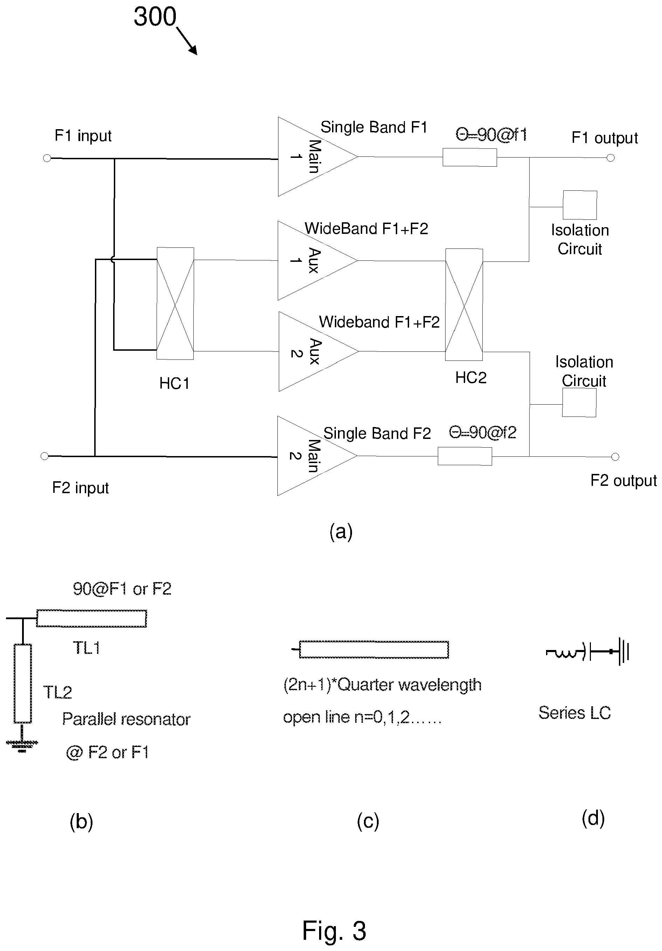

In order to filter out unwanted signal or short the unwanted signal to ground from the outputs of the power amplifier arrangement 100, 200, each output may comprise an isolation circuit or a short circuit as shown in **Figure 3 (a).** The isolation circuit may be a parallel resonator comprising two transmission lines **TL1, TL2** as shown in **Figure 3(b),** or a (2n+1)*Quarter wavelength open transmission line, n=0,1,2,... as shown in **Figure 3(c),** or a series Inductor -Capacitor (LC) resonance circuit, as shown in **Figure 3(d).**

The isolation circuit is short to ground for the signal at the resonance frequency of the isolation circuit, so it can isolate the leakage signal which should go out to another output port.

Therefore, according to some embodiment herein, the power amplifier arrangement 100, 200 may comprise multiple isolation resonation circuits coupled to the respective outputs of the power amplifier arrangement 100, 200. Each resonation isolation circuit is configured to resonance at a certain frequency to filter out the signal with this frequency from the output of the power amplifier arrangement.

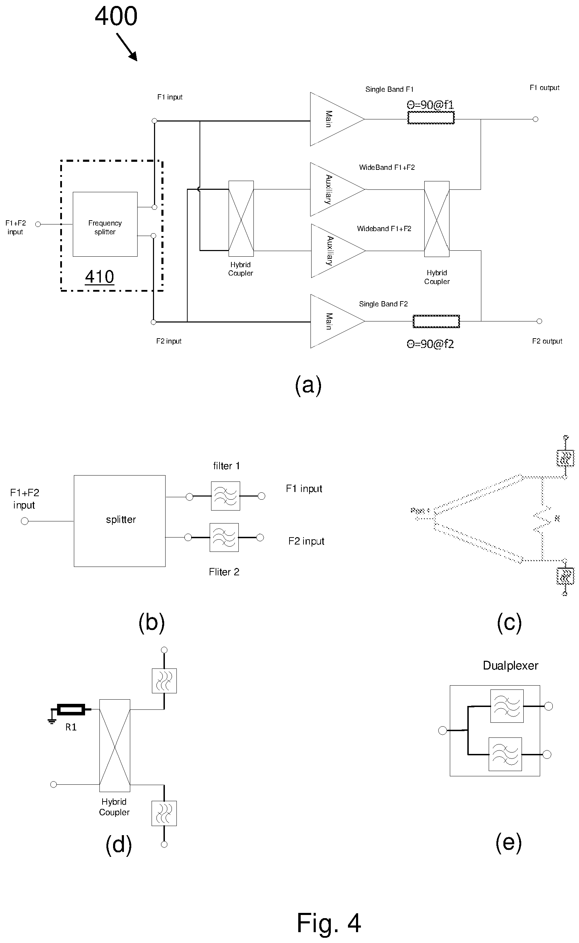

Although it is shown in Figures 1 and 2 that the inputs of the power amplifier arrangement 100, 200 for the multiple input signals are separate for each input signal, two or more inputs may be combined to one input. **Figure 4 (a)** shows an example dual-band power amplifier arrangement **400** with a single input **F1+F2 input.** The amplifier arrangement **400** comprises a signal splitter **410** configured to split a single input signal within a first and second frequency bands to two input signals with the first frequency band and the second frequency band respectively. The signal splitter 410 may be a combination of a frequency splitter and a filter as shown in **Figure 4 (b),** such as a combination of a Wilkinson divider and a filter, as shown in **Figure 4 (c),** a combination of a hybrid coupler and a filter, as shown in **Figure 4 (d),** or a dualplexer as shown in **Figure 4 (e).**

Therefore, according to some embodiments herein, the power amplifier arrangement 100, 200 may further comprise one or more signal splitters configured to split a single input signal to two or more input signals with respective frequency bands.

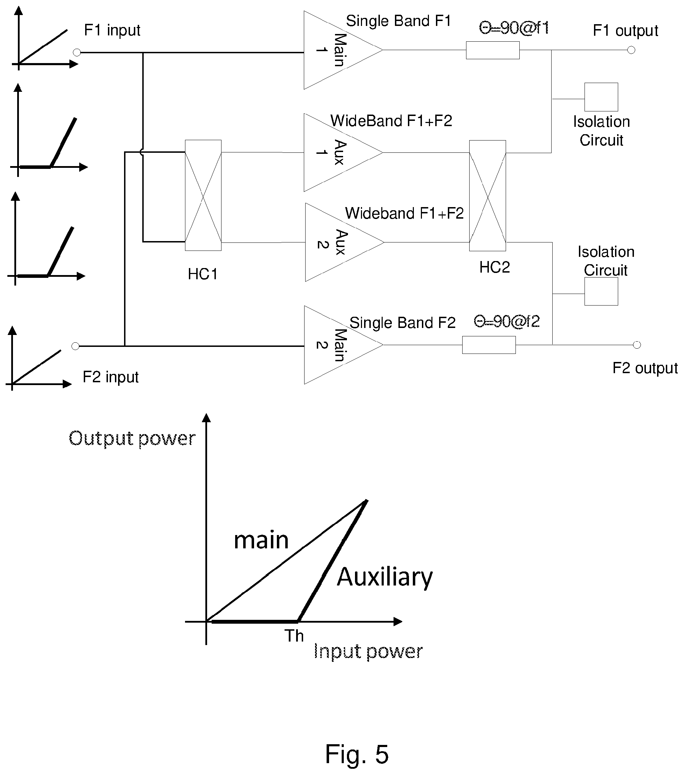

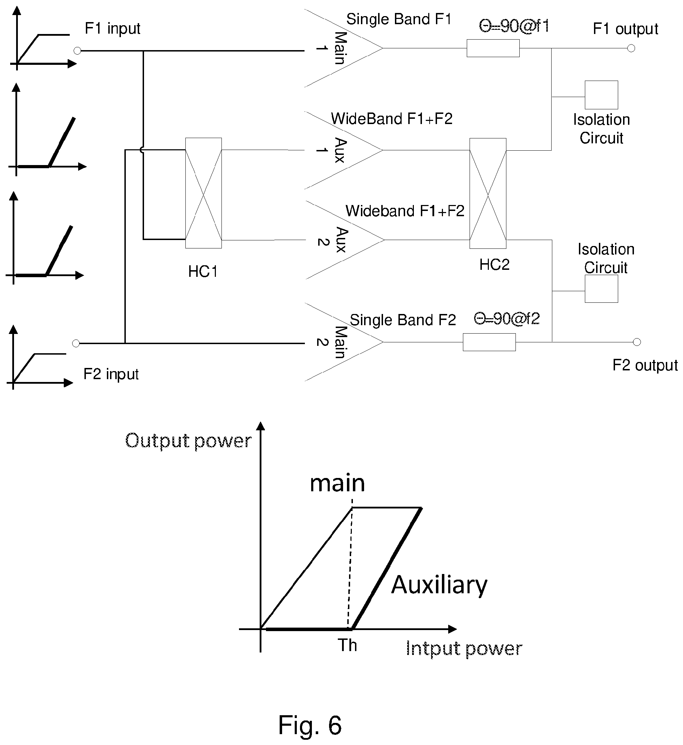

According to some embodiments herein, in order to control the phase and amplitude of the input signal for the main and auxiliary amplifiers respectively, the input signal may be split to two signals in digital domain, one is for the main amplifiers and the other is for the auxiliary amplifiers. **Figures 5 and 6** show examples of split input signals for the main and auxiliary amplifiers in digital domain. The input signals within frequency bands F1 and F2 for the first and second main amplifiers may be from one input signal with frequency splitter. The input signals within frequency bands F1 and F2 for the first and second auxiliary amplifiers may be from one input signal with frequency splitter.

In Figures 5 and 6, the left tabells shows the output power from digital domain on y-axis versus the input power on x-axis for each of the power amplifiers Main 1, Aux 1, Aux 2, Main 2. The output power from the digital domain finally will be the input power for the power amplifiers. The phase and amplitude of the input signal for the main and auxiliary amplifiers may be controlled in digital domain respectively.

The control purpose is that when the input signal power is below a threshold, shown as **Th** in Figure 5, of the auxiliary amplifiers, the auxiliary amplifiers are off, and the signal cannot go through and get amplified by the auxiliary amplifiers. So it is just wasted. Therefore, the output power from the digital domain for inputting to the auxiliary amplifiers is set to zero, i.e. turned off. When the input signal power is above the threshold of the auxiliary amplifiers, the output power from the digital domain for inputting to the auxiliary amplifiers is turned on. The slope of the output power from function block versus the input power function block for the main and auxiliary amplifiers may be changed separately and differently with regard to the original signal.

Therefore, according to some embodiments herein, the input signals for the main and auxiliary amplifiers may be split in digital domain to two signals, one is for inputting to the main amplifiers, and one is for inputting to the auxiliary amplifiers such that the phase and amplitude of the input signal for the main and auxiliary amplifiers may be controlled separately.

Splitting the input signals for the main and auxiliary amplifiers has following advantages:
The phase error between the main and auxiliary amplifiers due to different conditions, e.g. different signal powers or different temperatures may be reduced or compensated.

The input signal amplitude may be controlled for the main and auxiliary amplifiers separately, for example, when the input signal power below a threshold, the input for the auxiliary amplifiers may be turned off.

The input signal power for the main amplifiers may be controlled in order to avoid overdriving the main amplifiers, e.g. when the input signal power is above the saturation threshold of the main amplifiers, the output power from digital domain for inputting to the main amplifiers may be kept the same as when the main amplifier just gets saturated, as shown in Figure 6, where the saturation is shown by the output power from digital domain reaching a constant value.

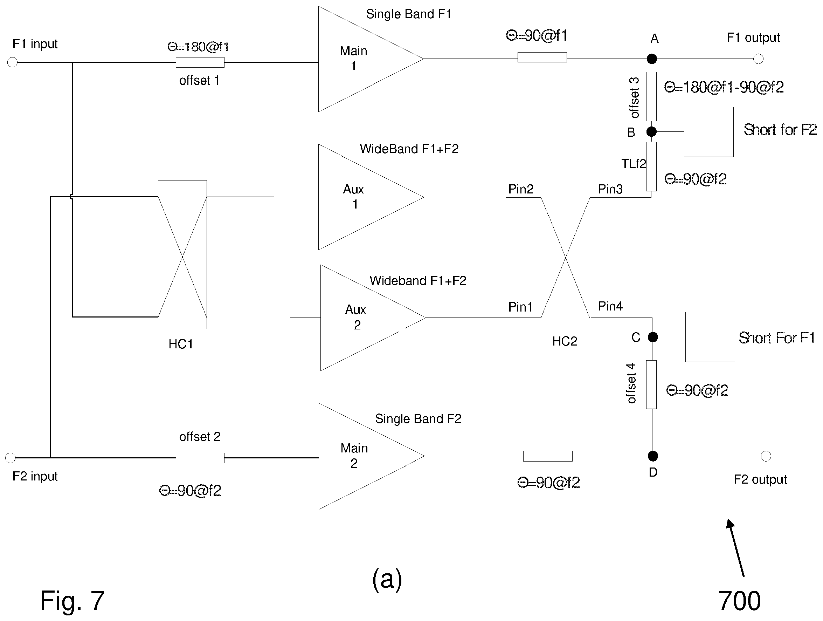

According to some embodiments herein, the first and second auxiliary amplifiers Aux 1, Aux 2, may have different bias condition for a sub-Doherty operation. **Figure 7 (a)** shows a principle structure of a power amplifier arrangement **700** for explaining a sub-Doherty function combining.

There are two alternatives:

a) Setting the first auxiliary amplifier Aux 1 input bias in light class C as main amplifier and setting the second auxiliary amplifier Aux 2 input bias in deep class C as auxiliary amplifier for sub-Doherty function.
b) Setting the second auxiliary amplifier Aux 2 input bias in light class C as main amplifier and setting the first auxiliary amplifier Aux 1 input bias in deep class C as auxiliary amplifier for sub-Doherty function.

For example, in Setting a): Aux 1 and Aux 2 are combined as a sub-Doherty function in which Aux 1 plays as "Main amplifier", hereafter referred as "sub-main amplifier", and Aux 2 plays as Auxiliary amplifier, hereafter referred as "sub-auxiliary amplifier".

By light/deep class C mode, it means that two amplifiers are biased in class C, one with a higher bias voltage, i.e. light class C, than another, i.e. deep class C. At lower signal power range, both amplifiers are off due to class C bias. At the medium signal power range, the light class-C biased amplifier is turned on whereas the deep class C biased amplifier is still off.

According to some embodiments herein, one main amplimer e.g. Main 1 or Main 2 and two auxiliary amplifiers Aux 1 and Aux 2 may be combined and work as a three-way Doherty power amplifier. That is if taking the two auxiliary amplifiers working as sub-Doherty function as a combined auxiliary amplifier, then the main amplifier and the combined auxiliary amplifier can combine to a top-level Doherty function.

A three-way Doherty PA consists of 3 branch amplifiers, namely a main amplifier, a first and a second auxiliary amplimers Aux 1, Aux 2. The 3 branch amplifiers cooperate at 3 different signal power ranges. At the low power range, only the main amplifier is working. At the medium power range, the main and Aux 1 are working. At the high power range, all 3 branches are working. As such, the efficiency is enhanced at 3 different power levels.

Sub-Doherty function combining means that the Aux 1 and Aux 2 in a three-way Doherty PA operate like a 2-way Doherty amplifier. That is, they turn on at different signal power levels and interact with each other similar as in a 2-way Doherty PA. They together serve as an auxiliary amplifier, interacting with the main amplifier in the three-way Doherty PA. The operation of the three-way Doherty amplifier and sub-Doherty function combining will be described in the following. To be simplify, taking 50 ohm as normalized impedance for this sub-Doherty function combining.

## Step 0

When the input signal is small enough, i.e. below a first threshold, Th1, both Aux 1 and Aux 2 are off, the main amplifier, e.g. Main 1, which is always on for it is biased at class AB or Class B.

Aux 1 and Aux 2 are off. For the output hybrid coupler HC2, Pin2 and Pin1 are open circuit.

For the first signal with the first band F1: Pin4 is short to ground. So the output impedance of Pin3 will be transferred to open circuit for the first signal with the first band F1. Phase **offset 3** shown as a transmission line, may be added in order to keep the total phase shifted from Pin3 output to **A** point, i.e., F1 output, the combining point with the first main amplifier, equal to 180 degrees, or n*180 degrees. That will keep the combined auxiliary amplifier as open circuit at the combining point A.

For the second signal with the second band F2: Pin3 is open circuit, i.e., the 1/4 wavelength transmission line **TLf2** transfers the short circuit **Short for F2,** to open circuit. So the Pin4 output impedance is short to ground for the second signal with the second frequency band F2. Phase **offset 4** shown as a transmission line, may be added to make the phase shifted with 90 degrees or (2n+1)*90 degrees from Pin4 to the combining point **D,** i.e., F2 output. That will make the combined auxiliary amplifier as open circuit at the combining point D.

And in this status, both the main amplifier for the first band F1 and the second main amplifier for the second band F2 are working in high efficiency with a 90-degree transmission line impedance transformer T1, T2 respectively.

## Step 1

When the input signal power increase from small to large, i.e. above the first threshold, Th1, the first auxiliary amplifier Aux 1, i.e. sub-main amplifier, will be turned on first and the Aux 2, i.e. sub-auxiliary amplifier, is still off.

For F1 band signal, the Aux 1 turns on, Aux 2 is off. For output hybrid coupler HC2, Pin4 is short for F1 band, Pin1 is open when Aux 2 is off. If output Pin3 for F1 band signal is connected with 50ohm load, the Pin2 output impedance will be transferred to high impedance 100 ohm for F1 band. It's load modulation for Aux 1 to work at high efficiency as a "main amplifier" in the sub-Doherty function for F1 band.

For F2 band signal, for the output hybrid coupler HC2, Pin3 is open for band F2, 1/4 wavelength transmission line transfer the short circuit to open. Pin1 is open when Aux 2 is off. If the output port Pin4 is connected to 50ohm load for F2 band, the Pin2 port impedance will be transferred to high impedance 100 ohm for F2 band. So that it's also load modulation for Aux 1 to work at high efficiency as a "main amplifier" for F2 band in the sub-Doherty function. In this example, Aux 1 is biased higher, i.e. light class C, compared to the Aux 2, so it plays as "main amplifier" for both F1 and F2 band in the sub-Doherty function.

The S parameter matrix for a 3 dB $90^0$ hybrid coupler is described by:

$$[S] = \begin{bmatrix} 0 & 0 & -j\dfrac{\sqrt{2}}{2} & \dfrac{\sqrt{2}}{2} \\ 0 & 0 & \dfrac{\sqrt{2}}{2} & -j\dfrac{\sqrt{2}}{2} \\ -j\dfrac{\sqrt{2}}{2} & \dfrac{\sqrt{2}}{2} & 0 & 0 \\ \dfrac{\sqrt{2}}{2} & -j\dfrac{\sqrt{2}}{2} & 0 & 0 \end{bmatrix}$$

The Pin2 load impedance modulation can be got from the S parameter when other 3 ports impedance are fixed.

In this step, for the top-level Doherty function, the power from Aux amplifier starts to inject to combined output with main amplifier. That lead the main amplifier's high load impedance decreased.

**Step 2**

Then when the signal increases enough, i.e. above a second threshold, Th2, the Aux 2 also will be turned on.

As the input signal power increases, the Aux 1 turns on firstly for it's biased in light class C, then Aux 2 turns on for it's biased in deep class C. The output power injected to the combining point, point A for F1 band, point D for F2 band, is increased. So the load impedance for the main amplifier will be modulated from high impedance to Zopt, an optimum impedance, e.g. 50 ohm. In this case, for sub-Doherty function, both Aux 1 and Aux 2 are turned on, so F1 band signals will be combined in phase at Pin3 of output hybrid coupler HC2 and F2 band signals will be combined in phase at Pin4 of output hybrid coupler HC2 which are same as in the basic architecture.

When the input signal power increases, more power from Aux 2 will be injected to the output port Pin3 of output hybrid coupler HC2 for F1 band and Pin 4 of output hybrid coupler HC2 for F2 band. It will modulate the Pin2 of output hybrid coupler HC2 impedance from 100 ohm to 50ohm for Aux 1 which is the same as the Doherty function.

The 90&180-degree transmission lines are exemplary in an ideal situation, for the functionality of an impedance inverter. It's well known for people skilled in the art that in practice, due to parasitic effects, transmission lines of other lengths will be used to achieve the impedance inversion function.

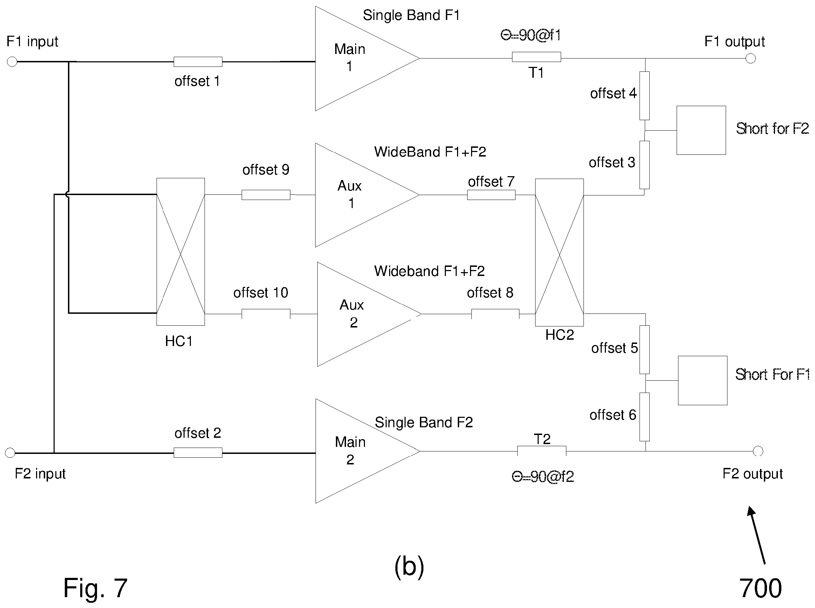

Same as Figure 2(a), Figure 7 (a) is only a basic principle structure of a dual-band power amplifier. In practical applications, matching networks or phase offset networks are always needed at the input and output of each auxiliary amplifier, between the outputs of a hybrid coupler and the outputs of the power amplifier arrangement, at the input of each main amplifier etc. to compensate the phase differences between the main and auxiliary amplifiers for the input signals to the input hybrid coupler HC1 and the output signals from the output hybrid coupler HC2. **Figure 7 (b)** shows a general structure of a power amplifier arrangement 700, where Aux 1 and Aux 2 may have different bias condition for a sub-Doherty function combining, and **phase offsets 1-10** are added at different locations. If adding a phase offset 7 and offset 8 at the outputs of Aux 1 and Aux 2 respectively, then the phase offset 3, offset 4, offset 5 and offset 6 need to be changed accordingly to achieve the same Doherty function.

Therefore, according to some embodiments herein, the first and second auxiliary amplifiers Aux 1, Aux 2 may be biased differently such that they are turned on at different input signal power level for a sub-Doherty function combining. For example, the first auxiliary amplifier Aux 1 may be configured to operate in light class C mode and the second auxiliary amplifier is configured to operate in deep class C mode, or the first auxiliary amplifier is configured to operate in deep class C mode and the second auxiliary amplifier is configured to operate in light class C mode by setting different biases for the first and second auxiliary amplifiers.

According to some embodiments herein, the power amplifier arrangement 100, 200, 300, 400, 700 may be configured for dynamic time-division-duplex operation. However, during dynamic time-division-duplex operation, for each frequency band, the other transmitting band signal will leakage to the receiver as noise. For example, when the transmitter TX1 is on and the receiver RX2 is on, Main 2 is turned off, but there is still leakage noise from the transmitter TX1 going through to the receiver RX2. Cancellation or isolation of the TX1 leakage from the RX2 is needed.

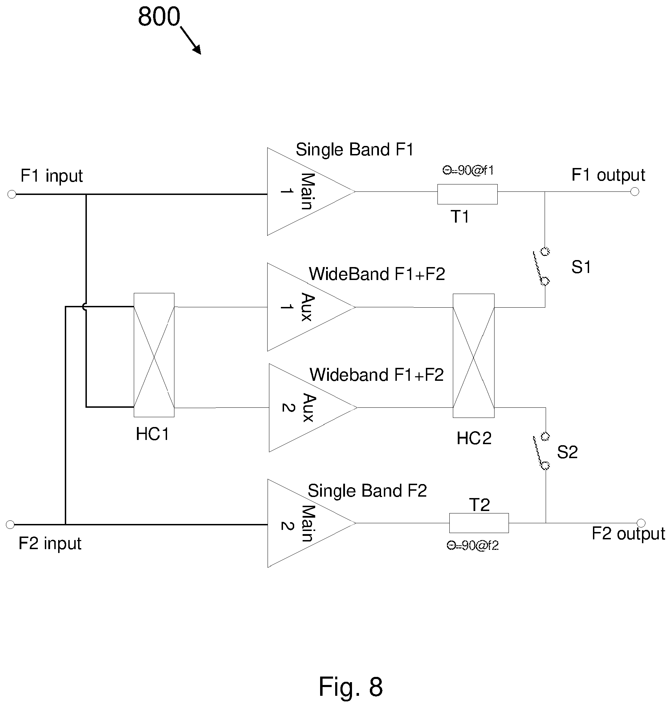

According to some embodiments herein, a switch may be added to each output of an output hybrid coupler in the power amplifier arrangement 100, 200, 300, 400, 700 to isolate the TX1 leakage from the RX2. Each output of an output hybrid coupler is coupled to an output of the power amplifier arrangement 100, 200, 300, 400, 700 via a switch. **Figure 8** shows an example of dual-band power amplifier arrangement **800** for a dynamic time-division-duplex operation.

The amplifier arrangement 800 comprises a first switch **S1** and a second switch **S2.** The first output of the second hybrid coupler **HC2** is coupled to the first output of the power amplifier arrangement 800 **F1 output** via the first switch S1, the second output of the second hybrid coupler HC2 is coupled to the second output of the power amplifier arrangement **F2 output** via the second switch S2.

During operation, when a transmitter **TX1** for transmitting a signal with the first frequency band F1 is on and a receiver **RX2** for receiving a signal with the second frequency band F2 is on, the first main amplifier Main 1 is set on and operating, the second main amplifier Main 2 is set off and not operating, the first switch S1 is turned on and the second switch S2 is turned off. When a transmitter **TX2** for transmitting a signal with the second frequency band F2 is on and a receiver **RX1** for receiving a signal with the first frequency band F1 is on, the first main amplifier Main 1 is set off and not operating, the second main amplifier Main 2 is set on and operating, the first switch S1 is turned off and the second switch S2 is turned on.

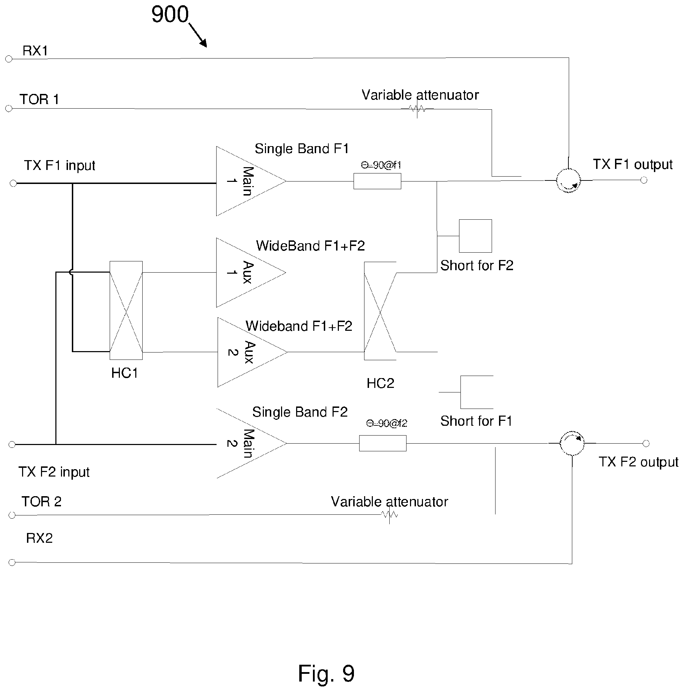

According to some embodiments herein, leakage cancellation may be implemented in the power amplifier arrangement 100, 200, 300, 400, 700. **Figure 9** shows an example implementation of leakage cancellation for the power amplifier arrangement 100, 200, 300, 400, 700. As shown in Figure 9, multiple transmitter observation receivers **TOR 1, TOR 2** are coupled to each output of the power amplifier arrangement 100, 200, 300, 400, 700 via e.g. a directional coupler to obtain the leakage signal from that output. For example, the leakage signal with the second frequency band, referred as TX1 F2 noise, can be obtained from the TOR 2. Then in digital domain, cancellation of the TX1 F2 noise for RX2 may be done so the remained signal is really the desired receiving signal with the second frequency band F2.

The variable attenuator in TOR transmitter observation receiver can be set in high attenuation when in TX mode because TX power is usually high and set in low attenuation when in RX mode for the noise power is usually low.

The couplings of the hybrid couplers to the auxiliary amplifiers, the inputs and outputs of the power amplifier arrangement 100, 200, 300, 400, 700, 800 and 90/180 degrees transmission lies shown in Figures 1, 2, 3, 4, 7, 8 are only exemplary. There are other different alternatives on the couplings of the hybrid couplers as long as at each output of the power amplifier arrangement, after a signal go through the hybrid couplers at the inputs and outputs of the power amplifier arrangement, the amplified signals within a certain frequency band output from the auxiliary amplifiers and main amplifier are combined in-phase at the output for providing the output signal within that frequency band. It is also possible to have more than one hybrid couplers at the inputs and outputs of the power amplifier arrangement 100, 200, 300, 400, 700, 800.

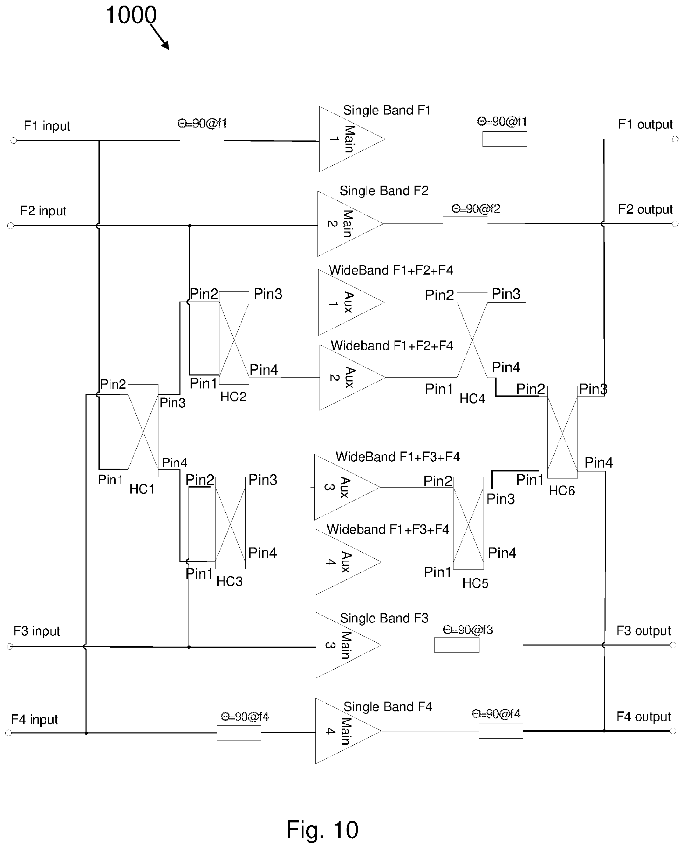

**Figure 10** shows an example embodiment of a four-band power amplifier arrangement **1000,** wherein there are 3 hybrid couplers at the inputs and 3 hybrid couplers at the outputs of the power amplifier arrangement 1000.

The power amplifier arrangement 1000 comprises four inputs **F1 input, F2 input, F3 input, F4 input,** each input is for receiving an input signal within one frequency band of the four frequency bands F1, F2, F3, F4, and four outputs **F1 output, F2 output, F3 output, F4 output,** each output is for providing an output signal within one frequency band of the four frequency bands F1, F2, F3, F4.

For example, the first input, F1 input, is for receiving a first input signal within a first frequency band F1, and the first output, F1 output, is for providing a first output signal within the first frequency band F1, etc.

The power amplifier arrangement 1000 further comprises four main amplifiers **Main 1, Main 2, Main 3, Main 4** and four auxiliary amplifiers **Aux 1, Aux 2, Aux 3, Aux 4.**

Inputs of the four main amplifiers are coupled to the respective inputs of the power amplifier arrangement 1000 for receiving the input signals within the respective frequency bands and outputs of the four main amplifiers are coupled to the respective outputs of the power amplifier arrangement 1000 for providing the output signals within the respective frequency bands.

For example, the input of the first main amplifier, Main 1, is coupled to the first input, F1 input, of the power amplifier arrangement 1000 and the output of the first main amplifier, Main 1, is coupled to the first output, F1 output, of the power amplifier arrangement 1000, etc.

Each of the four main amplifiers is configured as a narrow band amplifier for amplifying a signal within one frequency band of the four frequency bands F1, F2, F3, F4. For example, Main 1 is for amplifying a signal within the first frequency band F1, etc.

Each auxiliary amplifier is configured as a wideband amplifier for amplifying signals within at least two frequency bands of the four frequency bands F1, F2, F3, F4.

For example, the first and second auxiliary amplifiers Aux 1, Aux 2, each is configured as a wideband amplifier to amplify the input signals within the first, second and fourth frequency bands F1, F2, F4. The third and fourth auxiliary amplifiers Aux 3, Aux 4, each is configured as a wideband amplifier to amplify the input signals within the first, third and fourth frequency bands F1, F3, F4.

The power amplifier arrangement 1000 further comprises six hybrid couplers **HC1**, **HC2, HC3, HC4, HC5, HC6,** 3 hybrid couplers HC1, HC2, HC3 at the inputs and 3 hybrid couplers HC4, HC5, HC6 at the outputs. The terminals of the hybrid couplers are noted with **Pin1, Pin2, Pin3 Pin4** and have the same pin configurations as shown in Table 1.

The first and second auxiliary amplifiers Aux 1, Aux 2 are coupled between the second and fourth hybrid couplers HC2, HC4.

The third and fourth auxiliary amplifiers Aux 3, Aux 4 are coupled between the third and fifth hybrid couplers HC3, HC5.

The input of the first auxiliary amplifier Aux 1 is coupled to the second input of the power amplifier arrangement 1000 via the second hybrid coupler HC2.

The input of the second auxiliary amplifier Aux 2 is coupled to the first input of the power amplifier arrangement 1000 via the first and second hybrid couplers HC1, HC2.

The input of the third auxiliary amplifier Aux 3 is coupled to the fourth input of the power amplifier arrangement 1000 via the first and third hybrid couplers HC1, HC3. The input of the fourth auxiliary amplifier Aux 4 is coupled to the third input of the power amplifier arrangement 1000 via the third hybrid coupler HC3.

The hybrid couplers HC1, HC2, HC3 at the inputs of the power amplifier arrangement 1000 are coupled in the following way:

The first terminal Pin1 of the first hybrid coupler HC1 is coupled to the first input, F1 input, of the amplifier arrangement 1000;
The second terminal Pin2 of the first hybrid coupler HC1 is coupled to the fourth input, F4 input, of the amplifier arrangement 1000;
The third terminal Pin3 of the first hybrid coupler HC1 is coupled to the second terminal Pin2 of the second hybrid coupler HC2;
The fourth terminal Pin4 of the first hybrid coupler HC1 is coupled to the first terminal Pin1 of the second hybrid coupler HC2.
The first terminal Pin1 of the second hybrid coupler HC2 is coupled to the second input, F2 input, of the amplifier arrangement 1000;
The second terminal Pin2 of the second hybrid coupler HC2 is coupled to the third terminal Pin3 of the first hybrid coupler HC1;
The third terminal Pin3 of the second hybrid coupler HC2 is coupled to the input of the first auxiliary amplifiers Aux 1;
The fourth terminal Pin4 of the second hybrid coupler HC2 is coupled to the input of the second auxiliary amplifiers Aux 2.
The first terminal Pin1 of the third hybrid coupler HC3 is coupled to the fourth terminal Pin4 of the first hybrid coupler HC1;
The second terminal Pin2 of the third hybrid coupler HC3 is coupled to the third input, F3 input, of the amplifier arrangement 1000;
The third terminal Pin3 of the third hybrid coupler HC3 is coupled to the input of the third auxiliary amplifiers Aux 3;

The fourth terminal Pin4 of the third hybrid coupler HC3 is coupled to the input of the fourth auxiliary amplifiers Aux 4.

The hybrid couplers HC4, HC5, HC6 at the outputs of the power amplifier arrangement 1100 are coupled in the following way:

The first terminal Pin1 of the fourth hybrid coupler HC4 is coupled to the output of the second auxiliary amplifiers Aux 2;
The second terminal Pin2 of the fourth hybrid coupler HC4 is coupled to the output of the first auxiliary amplifiers Aux 1;
The third terminal Pin3 of the fourth hybrid coupler HC4 is coupled to the second output, F2 output, of the amplifier arrangement 1000;
The fourth terminal Pin4 of the fourth hybrid coupler HC4 is coupled to the second terminal Pin2 of the sixth hybrid coupler HC6.
The first terminal Pin1 of the fifth hybrid coupler HC5 is coupled to the output of the fourth auxiliary amplifiers Aux 4;
The second terminal Pin2 of the fifth hybrid coupler HC5 is coupled to the output of the third auxiliary amplifiers Aux 3;
The third terminal Pin3 of the fifth hybrid coupler HC5 is coupled to the first terminal Pin1 of the sixth hybrid coupler HC6;
The fourth terminal Pin4 of the fifth hybrid coupler HC5 is coupled to the third output, F3 output, of the amplifier arrangement 1000.
The first terminal Pin1 of the sixth hybrid coupler HC6 is coupled to the third terminal Pin3 of the fifth hybrid coupler HC5;
The second terminal Pin2 of the sixth hybrid coupler HC6 is coupled to the fourth terminal Pin4 of the fourth hybrid coupler HC4;
The third terminal Pin3 of the sixth hybrid coupler HC6 is coupled to the first output, F1 output, of the amplifier arrangement 1000;
The fourth terminal Pin4 of the sixth hybrid coupler HC6 is coupled to the fourth output, F4 output, of the amplifier arrangement 1000.

As discussed above, the couplings of the hybrid couplers to the auxiliary amplifiers, the inputs and outputs of the power amplifier arrangement 1000 and 90 degrees transmission lies shown in Figure 10 are only exemplary. It is possible to have different couplings of the hybrid couplers as long as at each output of the power amplifier arrangement, after a signal go through the hybrid couplers at the inputs and outputs of the power amplifier arrangement, the amplified signals within a certain frequency band output from the auxiliary amplifiers and main amplifier are combined in-phase at the output for providing the output signal within that frequency band.

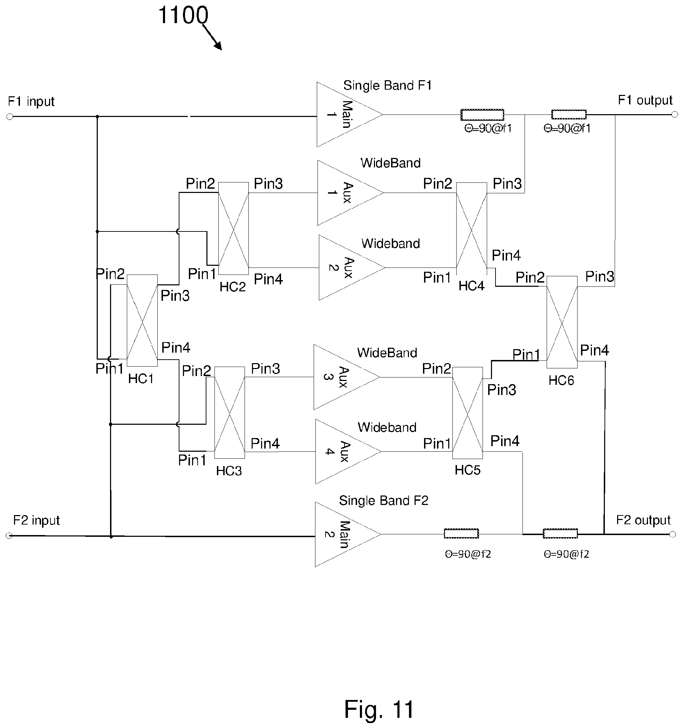

**Figure 11** shows an example embodiment of a dual-frequency band power amplifier arrangement **1100,** wherein there are 3 hybrid couplers at the inputs and 3 hybrid couplers at the outputs of the power amplifier arrangement 1000. The power amplifier arrangement 1100 in Figure 1100 is a sequential auxiliary architecture for reducing main amplifier load modulation. When the power from the auxiliary amplifier injects into the combining load, the load impedance will be increased for the main amplifier that is named active load modulation. When more power from the auxiliary amplifier injects into the combining load, the load will be increased more for the main amplifier. The high load modulation ratio will impact the matching bandwidth of matching network for the main amplifier. The load modulation ratio is the ratio of the load impedance after the load modulation to the load impedance before the load modulation.

In this architecture, the output from the auxiliary amplifier is split to two combining point. So the load modulate will be sequential, i.e. step by step, for the main amplifier. It will extend the bandwidth of matching network for the main amplifier.

The power amplifier arrangement 1100 comprises two inputs **F1 input, F2 input,** each input is for receiving an input signal within one frequency band of the two frequency bands F1, F2, and two outputs **F1 output, F2 output,** each output is for providing an output signal within one frequency band of the two frequency bands F1, F2.

For example, the first input, F1 input, is for receiving a first input signal within a first frequency band F1, and the first output, F1 output, is for providing a first output signal within the first frequency band F1, etc.

The power amplifier arrangement 1100 further comprises two main amplifiers **Main 1, Main 2** and four auxiliary amplifiers **Aux 1, Aux 2, Aux 3, Aux 4.**

Inputs of the two main amplifiers are coupled to the respective inputs of the power amplifier arrangement 1100 for receiving the input signals within the respective frequency bands and outputs of the two main amplifiers are coupled to the respective outputs of the power amplifier arrangement 1100 for providing the output signals within the respective frequency bands.

For example, the input of the first main amplifier, Main 1, is coupled to the first input, F1 input, of the power amplifier arrangement 1100 and the output of the first main amplifier, Main 1, is coupled to the first output, F1 output, of the power amplifier arrangement 1100, etc.

Each of the two main amplifiers is configured as a narrow band amplifier for amplifying a signal within one frequency band of the two frequency bands F1, F2. For example, Main 1 is for amplifying a signal within the first frequency band F1, etc.

Each auxiliary amplifier is configured as a wideband amplifier for amplifying signals within the two frequency bands F1, F2.

The power amplifier arrangement 1100 further comprises six hybrid couplers **HC1, HC2, HC3, HC4, HC5, HC6,** 3 hybrid couplers HC1, HC2, HC3 at the inputs and 3 hybrid couplers HC4, HC5, HC6 at the outputs. The terminals of the hybrid couplers are noted with **Pin1, Pin2, Pin3 Pin4** and has the same pin configurations as shown in Table 1.

The first and second auxiliary amplifiers Aux 1, Aux 2 are coupled between the second and fourth hybrid couplers HC2, HC4.

The third and fourth auxiliary amplifiers Aux 3, Aux 4 are coupled between the third and fifth hybrid couplers HC3, HC5.

The input of the first auxiliary amplifier Aux 1 is coupled to the first input of the power amplifier arrangement 1100 via the second hybrid coupler HC2.

The input of the second auxiliary amplifier Aux 2 is coupled to the first input of the power amplifier arrangement 1100 via the first and second hybrid couplers HC1, HC2.

The input of the third auxiliary amplifier Aux 3 is coupled to the second input of the power amplifier arrangement 1100 via the first and third hybrid couplers HC1, HC3.

The input of the fourth auxiliary amplifier Aux 4 is coupled to the second input of the power amplifier arrangement 1100 via the third hybrid coupler HC3. The hybrid couplers HC1, HC2, HC3 at the inputs of the power amplifier arrangement 1100 are coupled in the following way:

The first terminal Pin1 of the first hybrid coupler HC1 is coupled to the first input, F1 input, of the amplifier arrangement 1100;

The second terminal Pin2 of the first hybrid coupler HC1 is coupled to the second input, F2 input, of the amplifier arrangement 1100;

The third terminal Pin3 of the first hybrid coupler HC1 is coupled to the second terminal Pin2 of the second hybrid coupler HC2;

The fourth terminal Pin4 of the first hybrid coupler HC1 is coupled to the first terminal Pin1 of the second hybrid coupler HC2.

The first terminal Pin1 of the second hybrid coupler HC2 is coupled to the first input, F1 input, of the amplifier arrangement 1100;

The second terminal Pin2 of the second hybrid coupler HC2 is coupled to the third terminal Pin3 of the first hybrid coupler HC1;

The third terminal Pin3 of the second hybrid coupler HC2 is coupled to the input of the first auxiliary amplifiers Aux 1;

The fourth terminal Pin4 of the second hybrid coupler HC2 is coupled to the input of the second auxiliary amplifiers Aux 2.

The first terminal Pin1 of the third hybrid coupler HC3 is coupled to the fourth terminal Pin4 of the first hybrid coupler HC1;

The second terminal Pin2 of the third hybrid coupler HC3 is coupled to the second input, F2 input, of the amplifier arrangement 1100;

The third terminal Pin3 of the third hybrid coupler HC3 is coupled to the input of the third auxiliary amplifiers Aux 3;

The fourth terminal Pin4 of the third hybrid coupler HC3 is coupled to the input of the fourth auxiliary amplifiers Aux 4.

The hybrid couplers HC4, HC5, HC6 at the outputs of the power amplifier arrangement 1100 are coupled in the following way:

The first terminal Pin1 of the fourth hybrid coupler HC4 is coupled to the output of the second auxiliary amplifiers Aux 2;

The second terminal Pin2 of the fourth hybrid coupler HC4 is coupled to the output of the first auxiliary amplifiers Aux 1;

The third terminal Pin3 of the fourth hybrid coupler HC4 is coupled to the first output, F1 output, of the amplifier arrangement 1100 via a transmission line;

The fourth terminal Pin4 of the fourth hybrid coupler HC4 is coupled to the second terminal Pin2 of the sixth hybrid coupler HC6.

The first terminal Pin1 of the fifth hybrid coupler HC5 is coupled to the output of the fourth auxiliary amplifiers Aux 4;

The second terminal Pin2 of the fifth hybrid coupler HC5 is coupled to the output of the third auxiliary amplifiers Aux 3;

The third terminal Pin3 of the fifth hybrid coupler HC5 is coupled to the first terminal Pin1 of the sixth hybrid coupler HC6;

The fourth terminal Pin4 of the fifth hybrid coupler HC5 is coupled to the second output, F2 output, of the amplifier arrangement 1100 via a transmission line.

The first terminal Pin1 of the sixth hybrid coupler HC6 is coupled to the third terminal Pin3 of the fifth hybrid coupler HC5;

The second terminal Pin2 of the sixth hybrid coupler HC6 is coupled to the fourth terminal Pin4 of the fourth hybrid coupler HC4;

The third terminal Pin3 of the sixth hybrid coupler HC6 is coupled to the first output, F1 output, of the amplifier arrangement 1100;

The fourth terminal Pin4 of the sixth hybrid coupler HC6 is coupled to the second output, F2 output, of the amplifier arrangement 1100.

As discussed above, the couplings of the hybrid couplers to the auxiliary amplifiers, the inputs and outputs of the power amplifier arrangement 1100, and 90-degrees transmission lies shown in Figure 1100 are only exemplary. It is possible to have different couplings of the hybrid couplers as long as at each output of the power amplifier arrangement, after a signal go through the hybrid couplers at the inputs and outputs of the power amplifier arrangement, the amplified signals within a certain frequency band output from the auxiliary amplifiers and main amplifier are combined in-phase at the output for providing the output signal within that frequency band.

According to some embodiments herein, two or more of the dual-frequency band power amplifier arrangements 1100, or two or more of the four-frequency band power amplifier arrangement 1000, or a combination of the four-frequency band and dual-frequency band power amplifier arrangements 1000, 1100, or any combination of the power amplifier arrangements 200, 300, 400, 700, 800, 1000, 1100 may form a multiband power amplifier arrangement.

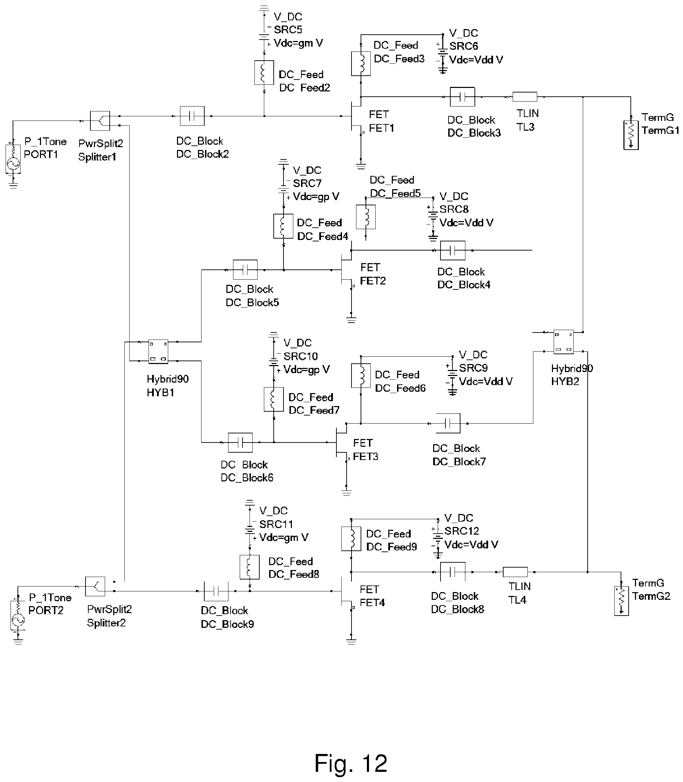

To illustrate the performance of the power amplifier arrangement 100, 200, 300, 400, 700, 800, 1000,1100, simulations have been done for different applications. **Figure 12** shows an example simulation circuit, where power amplifiers are shown as field-effect transistors (FET).

An ideal FET model with output drain current $I_{ds}$ shown as below is used for simulation:

$$I_{ds} = \frac{\beta(V_{gs} - V_{th})^2}{1 + b(V_{gs} - V_{th})} * (1 + \lambda * V_{ds}) * \tanh(\alpha * V_{ds}).$$

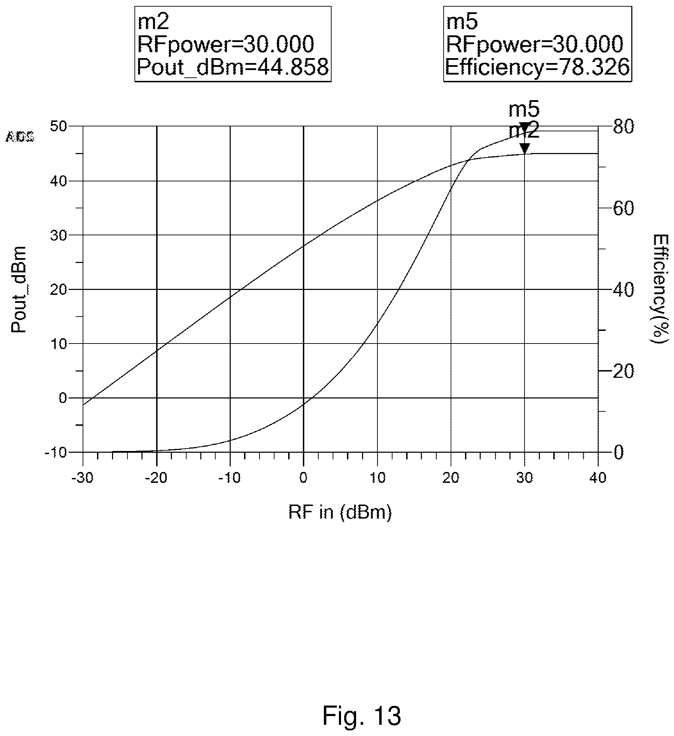

Setting e.g. $\beta = 0.08$, $b = 0.3$, $\lambda = 0.03$, $\alpha = 1.3$, $I_{max} = 2A$ is the maximum drain current of $I_{ds}$, and the direct current (DC) bias voltage at the drain to Vdd=50V. So, the peak output power is about 44dBm and efficiency is around 78% with 50ohm load and 30dBm input power, when a power amplifier with a FET is biased at class B mode. The simulation results for the power amplifier with a FET are shown in **Figure 13.**

The output impedance is open when the power amplifier with a FET is biased in class C mode, but when it's biased in class AB mode the output impedance is decreased that's because of the parameter λ which is related to the drain conductance.

The same FET model is used for 2 narrow band main amplifiers which are biased at class AB mode and 2 wideband auxiliary amplifiers which are biased at class C mode to form, for example, a symmetric dual band Doherty power amplifier.

The hybrid coupler is used as an input power divider and output power combiner for the 2 auxiliary amplifiers. As shown in Figure 12, the simulation circuit is based on the basic structure for the dual band power amplifier arrangement 200 shown in Figure 2, which have 2 input ports and 2 output ports. The upper ports are for F1 frequency band and the lower ports are for F2 frequency band. 3 typical application cases are simulated.

**Case 1:** input power ratio for F1 and F2 is F1:F2=1:0

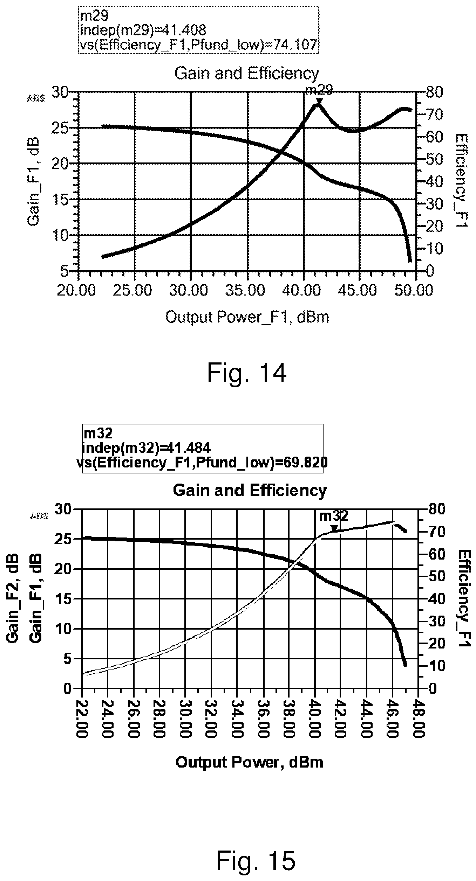

In this case, only signal with band F1 has power. The two auxiliary amplifiers are occupied by band F1. Peak output power is about 49.6dBm. The power backoff efficiency is around 74% at output power 41.5 dBm. The simulation results are shown in **Figure 14.**

**Case 2:** Input power ratio for F1 and F2 is F1:F2 =1:1

In this case, the input signal power is same for band F1 and band F2. The auxiliary amplifiers are shared for each band with the same power. The output power and performance are the same for both bands, and the peak power of each band is about 47dBm. The power backoff efficiency is around 69.8% at output power 41.5 dBm. The simulation results are shown in **Figure 15.**

**Case 3:** Input power ratio for F1 and F2 is F1:F2=1:0.25

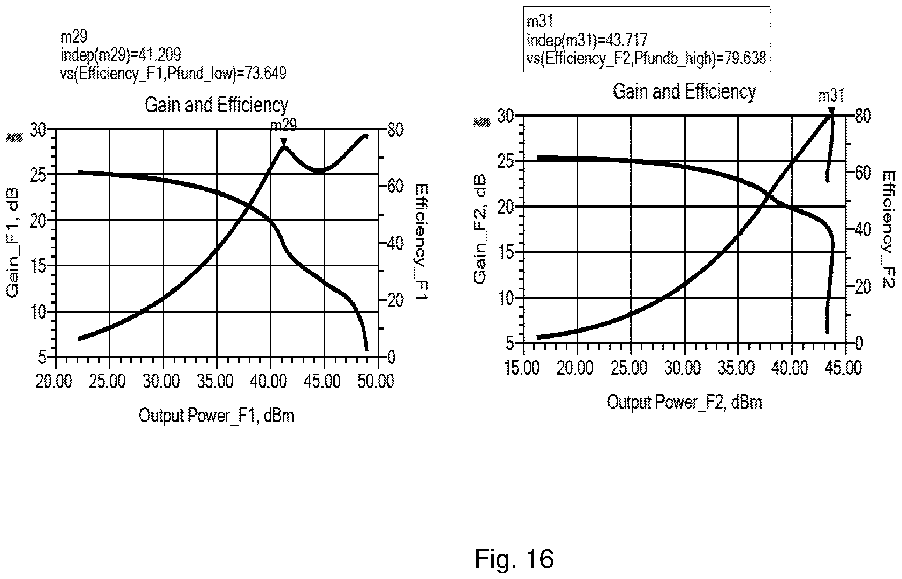

In this case, the input signal power for band F1 is 4 times of the band F2, the auxiliary amplifiers are almost occupied by band F1 signal. Band F2 signal is mainly amplified by the main amplifier for band F2. The peak power for band F1 is about 49dBm and the peak power for band F2 is about 44dBm. The efficiency is around 73.6% at power backoff to 41.2 dBm for band F1, around 79.6% at output power 43.7 dBm for band F2. The simulation results are shown in **Figure 16.**

If isolation circuits are added at the auxiliary amplifier output, higher efficiency performance can be achieved. The isolation circuit added at the output of the first auxiliary amplifier is short to ground for F2 band signal. The isolation circuit added at the output of the second auxiliary amplifier is short circuit for F1 band signal.

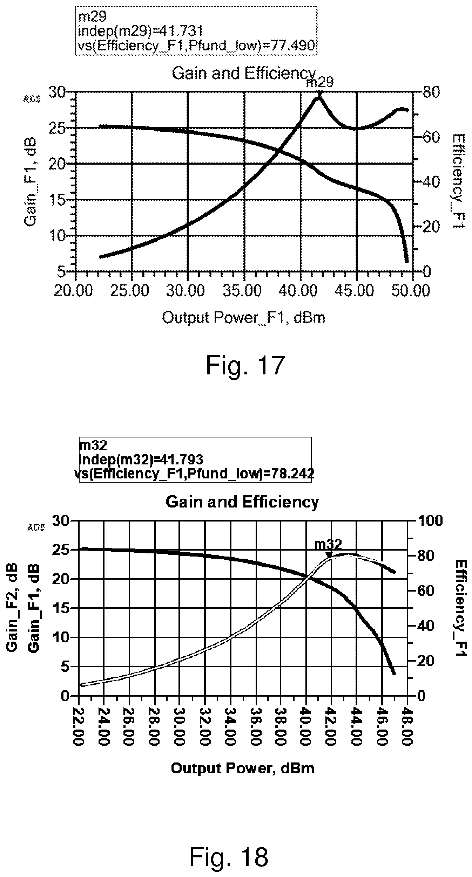

Simulation performance for case 1, case 2 and case 3 described above is shown as the following:
Case 1: Efficiency 77.5%, at 41.7dBm output power. The simulation results are shown in **Figure 17.**

Case 2: Efficiency 78.2%, at 41.7dBm output power. The simulation results are shown in **Figure 18.**

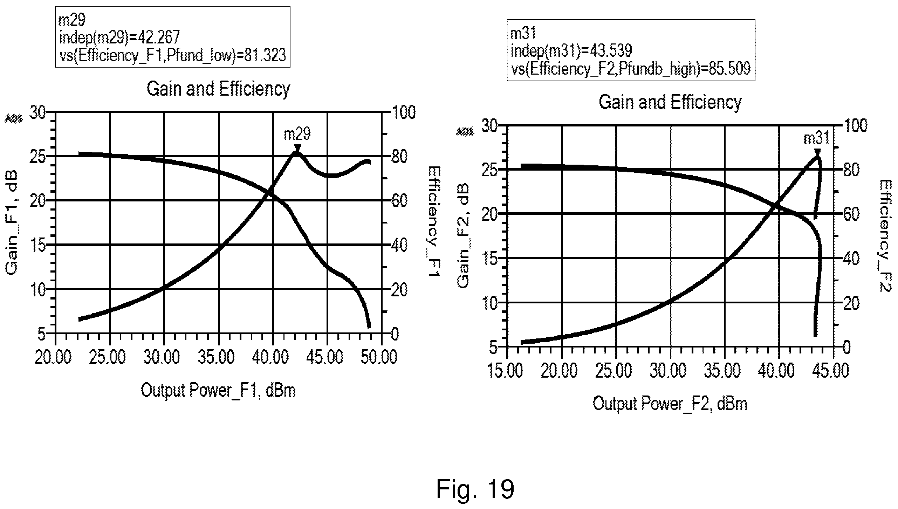

Case 3: Efficiency 81.3%, at 42.2 dBm output power for F1 Band, Efficiency 85.5%, at 43.5 dBm output power. The simulation results are shown in **Figure 19.**

As can be seen, the efficiency for each of the three application cases is higher than the original circuit without the isolation circuits.

Therefore, the power amplifier arrangement 100, 200, 300, 400, 700, 800, 1000, 1100 according to embodiments herein can achieve a multiband DPA performance with high efficiency with power pooling function as described above by the combined main and auxiliary amplifiers.

To summarize, in the power amplifier arrangement 100, 200, 300, 400, 700, 800, 1000, 1100 according to embodiments herein, for each output port, the narrow band main amplifier works at high efficiency status as a conventional narrow band DPAs, the wideband auxiliary amplifiers are sharing for different band signals which can support multiband power pooling application. With 3 dB 90-degree hybrid couplers, it's easy to divide the different band signal power for different band outputs. The power amplifier arrangement 100, 200, 300, 400, 700, 800, 1000, 1100 according to embodiments herein has N narrow-band outputs. The signal power from the N narrow-band main amplifiers and the wideband auxiliary amplifiers are combined at N different combining points, in contrast to the single power combining point in prior art solution. Thus, there is no need of a 1-to-N multiplexer at the PA output to feed N narrow-band filters, the insertion loss, volume, and weight of the radio units are thereby reduced.

The embodiments herein may be applied to multiway Doherty, symmetric Doherty, asymmetric Doherty, inverted Doherty and multistage Doherty power amplifers.

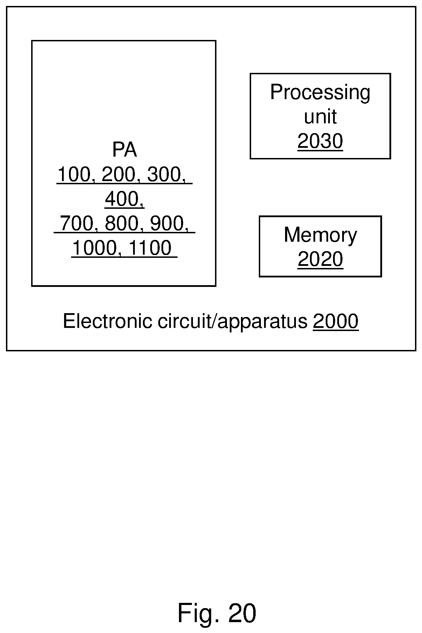

The power amplifier arrangement 100, 200, 300, 400, 700, 800, 1000, 1100 according to embodiments herein may be employed in various electronic circuits or apparatuses. **Figure 20** shows a block diagram for an electronic circuit or apparatus **2000.** The electronic circuit or apparatus 2000 comprises a power amplifier arrangement PA 100, 200, 300, 400, 700, 800, 1000, 1100 according to the embodiments herein. The electronic circuit or apparatus 2000 may be a transmitter or a transceiver in a cellular communications system/network. The electronic apparatus 2000 may comprise other units, where a memory **2020,** a processing unit **2030** are shown. The electronic apparatus 2000 may be a user equipment or a mobile device, a wireless communication device, a radio base station for a cellular communication system.

Those skilled in the art will understand that the power amplifier arrangement 100, 200, 300, 400, 700, 800, 1000, 1100 according to embodiments herein may be implemented by any semiconductor technology.

When using the word "comprise" or "comprising" it shall be interpreted as non- limiting, i.e. meaning "consist at least of".

The embodiments herein are not limited to the above described embodiments. Various alternatives and modifications may be used. Therefore, the above embodiments should not be taken as limiting the scope of the embodiments herein, which is defined by the appended claims.

**Claims**

1.  A power amplifier arrangement (100, 200, 300, 400, 700, 800, 900, 1000, 1100) for amplifying signals with multiple frequency bands (F1, F2, F3, ...Fn), wherein the power amplifier arrangement comprises:

    multiple inputs (F1 input, F2 input, ... Fn input), wherein each input is for receiving an input signal within one frequency band of the multiple frequency bands (F1, F2, F3... Fn);
    multiple outputs (F1 output, F2 output, ... Fn output), wherein each output is for providing an output signal within one frequency band of the multiple frequency bands (F1, F2, F3... Fn);
    multiple main amplifiers (Main 1, Main 2... Main n), wherein each of the multiple main amplifiers is configured as a narrow band amplifier for amplifying a signal within one frequency band of the multiple frequency bands (F1, F2, F3... Fn), and wherein inputs of the multiple main amplifiers are coupled to the respective inputs of the power amplifier arrangement for receiving the input signals within the respective frequency bands and outputs of the multiple main amplifiers are coupled to the respective outputs of the power amplifier arrangement for providing the output signals within the respective frequency bands;
    multiple auxiliary amplifiers (Aux 1, Aux 2..., Aux 2n), wherein each auxiliary amplifier is configured as a wideband amplifier for amplifying signals within at least two frequency bands (F1+F2, ... F2+F3...) of the multiple frequency bands (F1, F2, F3,... Fn);
    one or more input hybrid couplers at the inputs of the power amplifier arrangement; and
    one or more output hybrid couplers at the outputs of the power amplifier arrangement; and wherein
    an input of an auxiliary amplifier is coupled to one of the multiple inputs of the power amplifier arrangement (100, 200, 300, 400, 700, 800, 900, 1000, 1100) through one or more input hybrid couplers to receive the input signals within at least two frequency bands; and
    an output of an auxiliary amplifier is coupled to one of the multiple outputs of the power amplifier arrangement (100) through one or more output hybrid couplers such that an output signal from that auxiliary amplifier is split into different output signals within different frequency bands, and the signals within the same frequency band output from the main amplifier and auxiliary amplifiers are combined in-phase at the output of the power amplifier arrangement for providing the output signal within that frequency band.

2.  The power amplifier arrangement (100, 200, 300, 400, 700, 800, 900, 1000, 1100) according to claim 1, wherein each of the multiple main amplifiers is configured to amplify an input signal with a full power range, and each of the multiple auxiliary amplifiers is configured to amplify the input signal with a power range above a threshold.

3.  The power amplifier arrangement (100, 200, 300, 400,700, 800, 900, 1000, 1100) according to any one of claims 1-2, further comprising multiple isolation circuits coupled to the respective outputs of the power amplifier arrangement, wherein each isolation circuit is configured to resonance at a certain frequency to filter out the signal with this frequency from the output of the power amplifier arrangement.

4.  The power amplifier arrangement (100, 200, 300, 400, 700, 800, 900, 1000, 1100) according to any one of claims 1-3, further comprising one or more signal splitters (410) configured to split a single input signal to two or more input signals with respective frequency bands.

5.  The power amplifier arrangement (100, 200, 300, 400, 700, 800, 900, 1000, 1100) according to claim 4, wherein the signal splitter comprises any one of a dualplexer, a combination of a Wilkinson divider and a filter, a combination of a hybrid coupler and a filter.

6. The power amplifier arrangement (100, 200, 300, 400, 700, 800, 900, 1000, 1100) according to any one of claims 1-5, wherein the input signals for the main and auxiliary amplifiers are split in digital domain such that the amplitude and/or phase of the input signals for the main and auxiliary amplifiers are controlled, respectively.

7. The power amplifier arrangement (100, 200, 300, 400, 700, 800, 900, 1000, 1100) according to any one of claims 1-6, wherein the power amplifier arrangement further comprises multiple switches for a dynamic time-division-duplex operation, and wherein the outputs of the multiple hybrid couplers are coupled to the respective outputs of the power amplifier arrangement via the respective switches.

8. The power amplifier arrangement (100, 200, 300, 400, 700, 800, 900, 1000, 1100) according to any one of claims 1-7, wherein the power amplifier arrangement (200) is configured for operating in two frequency bands, and wherein the power amplifier arrangement (200) comprises:

   two inputs (F1 input, F2 input), each input is for receiving an input signal within one frequency band of the two frequency bands (F1, F2);
   two outputs (F1 output, F2 output), each output is for providing an output signal within one frequency band of the two frequency bands (F1, F2);
   two main amplifiers (Main 1, Main 2), wherein an input of a first main amplifier is coupled to the first input (F1 input) of the power amplifier arrangement (200) and an output of the first main amplifier is coupled to the first output (F1 output) of the power amplifier arrangement (200) through a first transmission line (T1), an input of a second main amplifier is coupled to the second input (F2 input) of the power amplifier arrangement (200) and an output of the second main amplifier is coupled to the second output (F2 output) of the power amplifier arrangement (200) through a second transmission line (T2);
   two auxiliary amplifiers (Aux 1, Aux 2); and
   two hybrid couplers (HC1, HC2); and wherein
   inputs of the auxiliary amplifiers are coupled to the inputs of the power amplifier arrangement (200) through the first hybrid coupler (HC1), outputs of the auxiliary amplifiers are coupled to the outputs of the power amplifier arrangement (200) through the second hybrid coupler (HC2).

9. The power amplifier arrangement (100, 200, 300, 400, 700, 800, 900, 1000, 1100) according to any one of claims 1-8, wherein one main amplifier and two auxiliary amplifiers in the power amplifier arrangement form a two-way Doherty power amplifier.

10. The power amplifier arrangement (100, 200, 300, 400, 700, 800, 900, 1000, 1100) according to any one of claims 1-8, wherein one main amplifier (Main 1, Main 2) and two auxiliary amplifiers (Aux 1, Aux 2) in the power amplifier arrangement form a three-way Doherty power amplifier.

11. The power amplifier arrangement (100, 200, 300, 400, 700, 800, 900, 1000, 1100) according to claim 10, wherein the first and second auxiliary amplifiers are biased differently such that they are turned on at different input signal power level and operate as a two-way Doherty power amplifier.

12. The power amplifier arrangement (100, 200, 300, 400, 700, 800, 900, 1000, 1100) according to any one of claims 1-7, wherein the power amplifier arrangement (1000) is configured as a four-band power amplifier (1000) and the power amplifier arrangement (1000) comprises:

   four inputs (F1 input, F2 input, F3 input, F4 input), each input is for receiving an input signal within one frequency band of the four frequency bands (F1, F2, F3, F4);
   four outputs (F1 output, F2 output, F3 output, F4 output), each output is for providing an output signal within one frequency band of the four frequency bands F1, F2, F3, F4;
   four main amplifiers (Main 1, Main 2, Main 3, Main 4), wherein inputs of the four main amplifiers are coupled to the respective inputs of the power amplifier arrangement (1000) for receiving the input signals within the respective frequency bands and outputs of the four main amplifiers are coupled to the respective outputs of the power amplifier arrangement 1000 for providing the output signals within the respective frequency bands;
   four auxiliary amplifiers (Aux 1, Aux 2, Aux 3, Aux 4); and
   six hybrid couplers (HC1, HC2, HC3, HC4, HC5, HC6), wherein 3 hybrid couplers (HC1, HC2, HC3) are at the inputs and 3 hybrid couplers (HC4, HC5, HC6) are at the outputs of the power amplifier arrangement (1000); and wherein

inputs of the auxiliary amplifiers are coupled to the inputs of the power amplifier arrangement (1000) through the input hybrid couplers (HC1, HC2, HC3), outputs of the auxiliary amplifiers are coupled to the outputs of the power amplifier arrangement (1000) through the output hybrid couplers (HC4, HC5, HC6).

13. The power amplifier arrangement (100, 200, 300, 400, 700, 800, 900, 1000, 1100) according to any one of claims 1-7, wherein the power amplifier arrangement (1100) is configured as a dual-band power amplifier (1100) and the power amplifier arrangement (1100) comprises:

two inputs (F1 input, F2 input), each input is for receiving an input signal within one frequency band of the two frequency bands (F1, F2);

two outputs (F1 output, F2 output), each output is for providing an output signal within one frequency band of the two frequency bands (F1, F2);

two main amplifiers (Main 1, Main 2), wherein inputs of the two main amplifiers are coupled to the respective inputs of the power amplifier arrangement (1100) for receiving the input signals within the respective frequency bands and outputs of the two main amplifiers are coupled to the respective outputs of the power amplifier arrangement (1100) for providing the output signals within the respective frequency bands;

four auxiliary amplifiers (Aux 1, Aux 2, Aux 3, Aux 4); and

six hybrid couplers (HC1, HC2, HC3, HC4, HC5, HC6), wherein 3 hybrid couplers (HC1, HC2, HC3) are at the inputs and 3 hybrid couplers (HC4, HC5, HC6) are at the outputs of the power amplifier arrangement (1100); and wherein

inputs of the auxiliary amplifiers are coupled to the inputs of the power amplifier arrangement (1100) through the input hybrid couplers (HC1, HC2, HC3), outputs of the auxiliary amplifiers are coupled to the outputs of the power amplifier arrangement (1100) through the output hybrid couplers (HC4, HC5, HC6).

14. A multiband power amplifier comprising one or more power amplifier arrangements (200, 300, 400, 700, 800, 900, 1000, 1100) according any one of claims 1-13.

15. An electronic apparatus comprising one or more power amplifier arrangements according to any one of claims 1-13.

16. The electronic apparatus according to claim 15, wherein the electronic apparatus is any one of a transmitter, a transceiver, a wireless communication device, a radio base station, a network node for a cellular communication system.

**Patentansprüche**

1. Leistungsverstärkeranordnung (100, 200, 300, 400, 700, 800, 900, 1000, 1100) zum Verstärken von Signalen mit mehreren Frequenzbändern (F1, F2, F3, ..., Fn), wobei die Leistungsverstärkeranordnung umfasst:

mehrere Eingänge (F1-Eingang, F2-Eingang, ... Fn-Eingang), wobei jeder Eingang zum Empfangen eines Eingangssignals innerhalb eines Frequenzbandes der mehreren Frequenzbänder (F1, F2, F3...Fn) dient;

mehrere Ausgänge (F1-Ausgang, F2-Ausgang, ..., Fn-Ausgang), wobei jeder Ausgang ein Ausgangssignal innerhalb eines Frequenzbandes der mehreren Frequenzbänder (F1, F2, F3...Fn) bereitstellt;

mehrere Hauptverstärker (Hauptverstärker 1, Hauptverstärker 2...Hauptverstärker n), wobei jeder der mehreren Hauptverstärker als Schmalbandverstärker zur Verstärkung eines Signals innerhalb eines Frequenzbandes der mehreren Frequenzbänder (F1, F2, F3... Fn) konfiguriert ist, und wobei Eingänge der mehreren Hauptverstärker mit den jeweiligen Eingängen der Leistungsverstärkeranordnung zum Empfangen der Eingangssignale innerhalb der jeweiligen Frequenzbänder gekoppelt sind und Ausgänge der mehreren Hauptverstärker mit den jeweiligen Ausgängen der Leistungsverstärkeranordnung zum Bereitstellen der Ausgangssignale innerhalb der jeweiligen Frequenzbänder gekoppelt sind;

mehrere Hilfsverstärker (Aux 1, Aux 2..., Aux 2n), wobei jeder Hilfsverstärker als Breitbandverstärker zum Verstärken von Signalen innerhalb von mindestens zwei Frequenzbändern (F1+F2, ...F2+F3...) der verschiedenen Frequenzbänder (F1, F2, F3,...Fn) konfiguriert ist;

einen oder mehrere Eingangshybridkoppler an den Eingängen der Leistungsverstärkeranordnung; und

einen oder mehrere Ausgangshybridkoppler an den Ausgängen der Leistungsverstärkeranordnung; und wobei ein Eingang eines Hilfsverstärkers über einen oder mehrere Eingangshybridkoppler mit einem der mehreren Eingänge der Leistungsverstärkeranordnung (100, 200, 300, 400, 700, 800, 900, 1000, 1100) gekoppelt ist, um die Eingangssignale innerhalb von mindestens zwei Frequenzbändern zu empfangen; und

der Ausgang eines Hilfsverstärkers über einen oder mehrere Ausgangshybridkoppler mit einem der mehreren Ausgänge der Leistungsverstärkeranordnung (100) gekoppelt ist, sodass ein Ausgangssignal dieses Hilfsverstärkers in verschiedene Ausgangssignale innerhalb verschiedener Frequenzbänder aufgeteilt wird, und die Signale innerhalb des gleichen Frequenzbandes, die vom Hauptverstärker und den Hilfsverstärkern ausgegeben werden, am Ausgang der Leistungsverstärkeranordnung phasengleich kombiniert werden, um das Ausgangssignal innerhalb dieses Frequenzbandes bereitzustellen.

2. Leistungsverstärkeranordnung (100, 200, 300, 400, 700, 800, 900, 1000, 1100) nach Anspruch 1, wobei jeder der mehreren Hauptverstärker so konfiguriert ist, dass er ein Eingangssignal mit einem vollen Leistungsbereich verstärkt, und jeder der mehreren Hilfsverstärker so konfiguriert ist, dass er das Eingangssignal mit einem Leistungsbereich oberhalb eines Schwellenwerts verstärkt.

3. Leistungsverstärkeranordnung (100, 200, 300, 400, 700, 800, 900, 1000, 1100) nach einem der Ansprüche 1-2, weiter mehrere Isolationsschaltungen umfassend, die mit den jeweiligen Ausgängen der Leistungsverstärkeranordnung verbunden sind, wobei jede Isolationsschaltung so konfiguriert ist, dass sie bei einer bestimmten Frequenz Resonanz erzeugt, um das Signal mit dieser Frequenz aus dem Ausgang der Leistungsverstärkeranordnung herauszufiltern.

4. Leistungsverstärkeranordnung (100, 200, 300, 400, 700, 800, 900, 1000, 1100) nach einem der Ansprüche 1-3, weiter einen oder mehrere Signalteiler (410) umfassend, die so konfiguriert sind, dass sie ein einzelnes Eingangssignal in zwei oder mehr Eingangssignale mit jeweils eigenen Frequenzbändern aufteilen.

5. Leistungsverstärkeranordnung (100, 200, 300, 400, 700, 800, 900, 1000, 1100) nach Anspruch 4, wobei der Signalteiler entweder einen Dualplexer, eine Kombination aus einem Wilkinson-Teiler und einem Filter oder eine Kombination aus einem Hybridkoppler und einem Filter umfasst.

6. Leistungsverstärkeranordnung (100, 200, 300, 400, 700, 800, 900, 1000, 1100) nach einem der Ansprüche 1-5, wobei die Eingangssignale für den Haupt- und den Hilfsverstärker im digitalen Bereich so aufgeteilt werden, dass jeweils die Amplitude und/oder die Phase der Eingangssignale für den Haupt- und den Hilfsverstärker gesteuert werden.

7. Leistungsverstärkeranordnung (100, 200, 300, 400, 700, 800, 900, 1000, 1100) nach einem der Ansprüche 1-6, wobei die Leistungsverstärkeranordnung weiter mehrere Schalter für einen dynamischen Zeitmultiplex-Duplex-Betrieb umfasst, und wobei Ausgänge der mehreren Hybridkoppler über die jeweiligen Schalter mit den jeweiligen Ausgängen der Leistungsverstärkeranordnung gekoppelt sind.

8. Leistungsverstärkeranordnung (100, 200, 300, 400, 700, 800, 900, 1000, 1100) nach einem der Ansprüche 1-7, wobei die Leistungsverstärkeranordnung (200) für den Betrieb in zwei Frequenzbändern konfiguriert ist und wobei die Leistungsverstärkeranordnung (200) umfasst:

zwei Eingänge (F1-Eingang, F2-Eingang), wobei jeder Eingang zum Empfangen eines Eingangssignals innerhalb eines Frequenzbandes der beiden Frequenzbänder (F1, F2) dient;
zwei Ausgänge (F1-Ausgang, F2-Ausgang), wobei jeder Ausgang zum Bereitstellen eines Ausgangssignals innerhalb eines Frequenzbandes der beiden Frequenzbänder (F1, F2) dient;
zwei Hauptverstärker (Hauptverstärker 1, Hauptverstärker 2), wobei ein Eingang eines ersten Hauptverstärkers mit dem ersten Eingang (F1-Eingang) der Leistungsverstärkeranordnung (200) gekoppelt ist und ein Ausgang des ersten Hauptverstärkers mit dem ersten Ausgang (F1-Ausgang) der Leistungsverstärkeranordnung (200) über eine erste Übertragungsleitung (T1) gekoppelt ist, ein Eingang eines zweiten Hauptverstärkers mit dem zweiten Eingang (F2-Eingang) der Leistungsverstärkeranordnung (200) gekoppelt ist und ein Ausgang des zweiten Hauptverstärkers mit dem zweiten Ausgang (F2-Ausgang) der Leistungsverstärkeranordnung (200) über eine zweite Übertragungsleitung (T2) gekoppelt ist;
zwei Hilfsverstärker (Aux 1, Aux 2); und
zwei Hybridkoppler (HC1, HC2); und wobei
Eingänge der Hilfsverstärker über den ersten Hybridkoppler (HC1) mit den Eingängen der Leistungsverstärkeranordnung (200) gekoppelt sind, Ausgänge der Hilfsverstärker sind über den zweiten Hybridkoppler (HC2) mit den Ausgängen der Leistungsverstärkeranordnung (200) gekoppelt sind.

9. Leistungsverstärkeranordnung (100, 200, 300, 400, 700, 800, 900, 1000, 1100) nach einem der Ansprüche 1-8, wobei ein Hauptverstärker und zwei Hilfsverstärker in der Leistungsverstärkeranordnung einen Zweiwege-Doherty-Leistungsverstärker bilden.

10. Leistungsverstärkeranordnung (100, 200, 300, 400, 700, 800, 900, 1000, 1100) nach einem der Ansprüche 1-8, wobei ein Hauptverstärker (Hauptverstärker 1, Hauptverstärker 2) und zwei Hilfsverstärker (Aux 1, Aux 2) in der Leistungsverstärkeranordnung einen dreifachen Doherty-Leistungsverstärker bilden.

11. Leistungsverstärkeranordnung (100, 200, 300, 400, 700, 800, 900, 1000, 1100) nach Anspruch 10, wobei der erste und der zweite Hilfsverstärker unterschiedlich vorgespannt sind, sodass sie bei unterschiedlichen Eingangssignalleistungspegeln eingeschaltet werden und als Zweiwege-Doherty-Leistungsverstärker arbeiten.

12. Leistungsverstärkeranordnung (100, 200, 300, 400, 700, 800, 900, 1000, 1100) nach einem der Ansprüche 1-7, wobei die Leistungsverstärkeranordnung (1000) als Vierband-Leistungsverstärker (1000) konfiguriert ist und die Leistungsverstärkeranordnung (1000) Folgendes umfasst:

vier Eingänge (F1-Eingang, F2-Eingang, F3-Eingang, F4-Eingang), wobei jeder Eingang zum Empfangen eines Eingangssignals innerhalb eines Frequenzbandes der vier Frequenzbänder (F1, F2, F3, F4) dient;
vier Ausgänge (F1-Ausgang, F2-Ausgang, F3-Ausgang, F4-Ausgang), wobei jeder Ausgang ein Ausgangssignal innerhalb eines Frequenzbandes der vier Frequenzbänder F1, F2, F3, F4 bereitstellt;
vier Hauptverstärker (Hauptverstärker 1, Hauptverstärker 2, Hauptverstärker 3, Hauptverstärker 4), wobei Eingänge der vier Hauptverstärker mit den jeweiligen Eingängen der Leistungsverstärkeranordnung (1000) zum Empfangen der Eingangssignale innerhalb der jeweiligen Frequenzbänder gekoppelt sind und Ausgänge der vier Hauptverstärker mit den jeweiligen Ausgängen der Leistungsverstärkeranordnung 1000 zum Bereitstellen der Ausgangssignale innerhalb der jeweiligen Frequenzbänder gekoppelt sind;
vier Hilfsverstärker (Aux 1, Aux 2, Aux 3, Aux 4); und
sechs Hybridkoppler (HC1, HC2, HC3, HC4, HC5, HC6), wobei sich 3 Hybridkoppler (HC1, HC2, HC3) an den Eingängen und 3 Hybridkoppler (HC4, HC5, HC6) an den Ausgängen der Leistungsverstärkeranordnung (1000) befinden; und wobei
die Eingänge der Hilfsverstärker über die Eingangshybridkoppler (HC1, HC2, HC3) mit den Eingängen der Leistungsverstärkeranordnung (1000) gekoppelt sind, die Ausgänge der Hilfsverstärker über die Ausgangshybridkoppler (HC4, HC5, HC6) mit den Ausgängen der Leistungsverstärkeranordnung (1000) gekoppelt sind.

13. Leistungsverstärkeranordnung (100, 200, 300, 400, 700, 800, 900, 1000, 1100) nach einem der Ansprüche 1-7, wobei die Leistungsverstärkeranordnung (1100) als Dualband-Leistungsverstärker (1100) konfiguriert ist und die Leistungsverstärkeranordnung (1100) umfasst:

zwei Eingänge (F1-Eingang, F2-Eingang), wobei jeder Eingang zum Empfangen eines Eingangssignals innerhalb eines Frequenzbandes der beiden Frequenzbänder (F1, F2) dient;
zwei Ausgänge (F1-Ausgang, F2-Ausgang), wobei jeder Ausgang zum Bereitstellen eines Ausgangssignals innerhalb eines Frequenzbandes der beiden Frequenzbänder (F1, F2) dient;
zwei Hauptverstärker (Hauptverstärker 1, Hauptverstärker 2), wobei Eingänge der beiden Hauptverstärker mit den jeweiligen Eingängen der Leistungsverstärkeranordnung (1100) zum Empfangen der Eingangssignale innerhalb der jeweiligen Frequenzbänder gekoppelt sind und Ausgänge der beiden Hauptverstärker mit den jeweiligen Ausgängen der Leistungsverstärkeranordnung (1100) zum Bereitstellen der Ausgangssignale innerhalb der jeweiligen Frequenzbänder gekoppelt sind;
vier Hilfsverstärker (Aux 1, Aux 2, Aux 3, Aux 4); und
sechs Hybridkoppler (HC1, HC2, HC3, HC4, HC5, HC6), wobei sich 3 Hybridkoppler (HC1, HC2, HC3) an den Eingängen und 3 Hybridkoppler (HC4, HC5, HC6) an den Ausgängen der Leistungsverstärkeranordnung (1100) befinden; und wobei
Eingänge der Hilfsverstärker über die Eingangshybridkoppler (HC1, HC2, HC3) mit den Eingängen der Leistungsverstärkeranordnung (1100) gekoppelt sind, Ausgänge der Hilfsverstärker über die Ausgangshybridkoppler (HC4, HC5, HC6) mit den Ausgängen der Leistungsverstärkeranordnung (1100) gekoppelt sind.

14. Multiband-Leistungsverstärker mit einer oder mehreren Leistungsverstärkeranordnungen (200, 300, 400, 700, 800, 900, 1000, 1100) nach einem der Ansprüche 1-13.

15. Elektronische Einrichtung, umfassend eine oder mehrere Leistungsverstärkeranordnungen nach einem der Ansprüche 1-13.

**16.** Elektronische Einrichtung nach Anspruch 15, wobei es sich bei der elektronischen Einrichtung um einen Sender, einen Transceiver, eine drahtlose Kommunikationsvorrichtung, eine Funkbasisstation oder einen Netzwerkknoten für ein Mobilkommunikationssystem handelt.

**Revendications**

**1.** Agencement d'amplificateurs de puissance (100, 200, 300, 400, 700, 800, 900, 1000, 1100) destiné à amplifier des signaux à multiples bandes de fréquences (F1, F2, F3, ...Fn), dans lequel l'agencement d'amplificateurs de puissance comprend :

de multiples entrées (entrée F1, entrée F2, ... entrée Fn), dans lequel chaque entrée est destinée à recevoir un signal d'entrée dans une bande de fréquence des multiples bandes de fréquences (F1, F2, F3...Fn) ;
de multiples sorties (sortie F1, sortie F2, ...sortie Fn), dans lequel chaque sortie est destinée à fournir un signal de sortie dans une bande de fréquences des multiples bandes de fréquences (F1, F2, F3...Fn) ;
de multiples amplificateurs principaux (Principal 1, Principal 2...Principal n), dans lequel chacun des multiples amplificateurs principaux est configuré comme un amplificateur à bande étroite pour amplifier un signal dans une bande de fréquences des multiples bandes de fréquences (F1, F2, F3... Fn), et dans lequel les entrées des multiples amplificateurs principaux sont couplées aux entrées respectives de l'agencement d'amplificateurs de puissance pour recevoir les signaux d'entrée dans les bandes de fréquences respectives et les sorties des multiples amplificateurs principaux sont couplées aux sorties respectives de l'agencement d'amplificateurs de puissance pour fournir les signaux de sortie dans les bandes de fréquences respectives ;
de multiples amplificateurs auxiliaires (Aux 1, Aux 2..., Aux 2n), dans lequel chaque amplificateur auxiliaire est configuré comme un amplificateur à large bande pour amplifier les signaux dans au moins deux bandes de fréquences (F1+F2, ...F2+F3...) des multiples bandes de fréquences (F1, F2, F3,...Fn) ;
un ou plusieurs coupleurs hybrides d'entrée aux entrées de l'agencement d'amplificateurs de puissance ; et
un ou plusieurs coupleurs hybrides de sortie aux sorties de l'agencement d'amplificateurs de puissance ; et dans lequel
une entrée d'un amplificateur auxiliaire est couplée à l'une des multiples entrées de l'agencement d'amplificateurs de puissance (100, 200, 300, 400, 700, 800, 900, 1000, 1100) par l'intermédiaire d'un ou plusieurs coupleurs hybrides d'entrée afin de recevoir les signaux d'entrée dans au moins deux bandes de fréquences ; et
une sortie d'un amplificateur auxiliaire est couplée à l'une des multiples sorties de l'agencement d'amplificateurs de puissance (100) par l'intermédiaire d'un ou plusieurs coupleurs hybrides de sortie de sorte qu'un signal de sortie de cet amplificateur auxiliaire soit divisé en différents signaux de sortie dans différentes bandes de fréquences, et les signaux dans la même bande de fréquences sortis de l'amplificateur principal et des amplificateurs auxiliaires sont combinés en phase à la sortie de l'agencement d'amplificateurs de puissance pour fournir le signal de sortie dans cette bande de fréquences.

**2.** Agencement d'amplificateurs de puissance (100, 200, 300, 400, 700, 800, 900, 1000, 1100) selon la revendication 1, dans lequel chacun des multiples amplificateurs principaux est configuré pour amplifier un signal d'entrée avec une gamme de puissance complète, et chacun des multiples amplificateurs auxiliaires est configuré pour amplifier le signal d'entrée avec une gamme de puissance supérieure à un seuil.

**3.** Agencement d'amplificateurs de puissance (100, 200, 300, 400, 700, 800, 900, 1000, 1100) selon l'une quelconque des revendications 1-2, comprenant en outre de multiples circuits d'isolation couplés aux sorties respectives de l'agencement d'amplificateurs de puissance, dans lequel chaque circuit d'isolation est configuré pour résonner à une certaine fréquence afin de filtrer le signal avec cette fréquence de la sortie de l'agencement d'amplificateurs de puissance.

**4.** Agencement d'amplificateurs de puissance (100, 200, 300, 400, 700, 800, 900, 1000, 1100) selon l'une quelconque des revendications 1-3, comprenant en outre un ou plusieurs séparateurs de signaux (410) configurés pour diviser un seul signal d'entrée en deux signaux d'entrée ou plus avec des bandes de fréquences respectives.

**5.** Agencement d'amplificateurs de puissance (100, 200, 300, 400, 700, 800, 900, 1000, 1100) selon la revendication 4, dans lequel le séparateur de signal comprend l'un quelconque parmi un duplexeur, une combinaison d'un diviseur Wilkinson et d'un filtre, une combinaison d'un coupleur hybride et d'un filtre.

**6.** Agencement d'amplificateurs de puissance (100, 200, 300, 400, 700, 800, 900, 1000, 1100) selon l'une quelconque des revendications 1-5, dans lequel les signaux d'entrée des amplificateurs principaux et auxiliaires sont séparés dans le domaine numérique de sorte que l'amplitude et/ou la phase des signaux d'entrée des amplificateurs principaux et auxiliaires soit commandée respectivement.

7. Agencement d'amplificateurs de puissance (100, 200, 300, 400, 700, 800, 900, 1000, 1100) selon l'une quelconque des revendications 1-6, dans lequel l'agencement d'amplificateurs de puissance comprend en outre de multiples commutateurs pour un fonctionnement dynamique en duplex temporel, et dans lequel les sorties des multiples coupleurs hybrides sont couplées aux sorties respectives de l'agencement d'amplificateurs de puissance via les commutateurs respectifs.

8. Agencement d'amplificateurs de puissance (100, 200, 300, 400, 700, 800, 900, 1000, 1100) selon l'une quelconque des revendications 1-7, dans lequel l'agencement d'amplificateurs de puissance (200) est configuré pour fonctionner dans deux bandes de fréquences, et dans lequel l'agencement d'amplificateurs de puissance (200) comprend :

deux entrées (entrée F1, entrée F2), chaque entrée est destinée à recevoir un signal d'entrée dans une bande de fréquences des deux bandes de fréquences (F1, F2) ;
deux sorties (sortie F1, sortie F2), chaque sortie est destinée à fournir un signal de sortie dans une bande de fréquences des deux bandes de fréquences (F1, F2) ;
deux amplificateurs principaux (Principal 1, Principal 2), dans lequel une entrée d'un premier amplificateur principal est couplée à la première entrée (entrée F1) de l'agencement d'amplificateurs de puissance (200) et une sortie du premier amplificateur principal est couplée à la première sortie (sortie F1) de l'agencement d'amplificateurs de puissance (200) par l'intermédiaire d'une première ligne de transmission (T1), une entrée d'un second amplificateur principal est couplée à la seconde entrée (entrée F2) de l'agencement d'amplificateurs de puissance (200) et une sortie du second amplificateur principal est couplée à la seconde sortie (sortie F2) de l'agencement d'amplificateurs de puissance (200) par l'intermédiaire d'une seconde ligne de transmission (T2) ;
deux amplificateurs auxiliaires (Aux 1, Aux 2) ; et
deux coupleurs hybrides (HC1, HC2) ; et dans lequel
les entrées des amplificateurs auxiliaires sont couplées aux entrées de l'agencement d'amplificateurs de puissance (200) via le premier coupleur hybride (HC1), les sorties des amplificateurs auxiliaires sont couplées aux sorties de l'agencement d'amplificateurs de puissance (200) via le second coupleur hybride (HC2).

9. Agencement d'amplificateurs de puissance (100, 200, 300, 400, 700, 800, 900, 1000, 1100) selon l'une quelconque des revendications 1-8, dans lequel un amplificateur principal et deux amplificateurs auxiliaires dans l'agencement d'amplificateurs de puissance forment un amplificateur de puissance Doherty à deux voies.

10. Agencement d'amplificateurs de puissance (100, 200, 300, 400, 700, 800, 900, 1000, 1100) selon l'une quelconque des revendications 1-8, dans lequel un amplificateur principal (Principal 1, Principal 2) et deux amplificateurs auxiliaires (Aux 1, Aux 2) dans l'agencement d'amplificateurs de puissance forment un amplificateur de puissance Doherty à trois voies.

11. Agencement d'amplificateurs de puissance (100, 200, 300, 400, 700, 800, 900, 1000, 1100) selon la revendication 10, dans lequel les premier et second amplificateurs auxiliaires sont polarisés différemment de sorte qu'ils soient activés à des niveaux de puissance de signal d'entrée différents et fonctionnent comme un amplificateur de puissance Doherty à deux voies.

12. Agencement d'amplificateurs de puissance (100, 200, 300, 400, 700, 800, 900, 1000, 1100) selon l'une quelconque des revendications 1-7, dans lequel l'agencement d'amplificateurs de puissance (1000) est configuré comme un amplificateur de puissance à quatre bandes (1000) et l'agencement d'amplificateurs de puissance (1000) comprend :

quatre entrées (entrée F1, entrée F2, entrée F3, entrée F4), chaque entrée est destinée à recevoir un signal d'entrée dans une bande de fréquences des quatre bandes de fréquences (F1, F2, F3, F4) ;
quatre sorties (sortie F1, sortie F2, sortie F3, sortie F4), chaque sortie est destinée à fournir un signal de sortie dans une bande de fréquences des quatre bandes de fréquences (F1, F2, F3, F4) ;
quatre amplificateurs principaux (Principal 1, Principal 2, Principal 3, Principal 4), dans lequel les entrées des quatre amplificateurs principaux sont couplées aux entrées respectives de l'agencement d'amplificateurs de puissance (1000) pour recevoir les signaux d'entrée dans les bandes de fréquences respectives et les sorties des quatre amplificateurs principaux sont couplées aux sorties respectives de l'agencement d'amplificateurs de puissance (1000) pour fournir les signaux de sortie dans les bandes de fréquences respectives ;

quatre amplificateurs auxiliaires (Aux 1, Aux 2, Aux 3, Aux 4) ; et

six coupleurs hybrides (HC1, HC2, HC3, HC4, HC5, HC6), dans lequel 3 coupleurs hybrides (HC1, HC2, HC3) sont situés aux entrées et 3 coupleurs hybrides (HC4, HC5, HC6) sont situés aux sorties de l'agencement d'amplificateurs de puissance (1000) ; et dans lequel

les entrées des amplificateurs auxiliaires sont couplées aux entrées de l'agencement d'amplificateurs de puissance (1000) par l'intermédiaire des coupleurs hybrides d'entrée (HC1, HC2, HC3), les sorties des amplificateurs auxiliaires sont couplées aux sorties de l'agencement d'amplificateurs de puissance (1000) par l'intermédiaire des coupleurs hybrides de sortie (HC4, HC5, HC6).

13. Agencement d'amplificateurs de puissance (100, 200, 300, 400, 700, 800, 900, 1000, 1100) selon l'une quelconque des revendications 1-7, dans lequel l'agencement d'amplificateurs de puissance (1100) est configuré comme un amplificateur de puissance à double bande (1100) et l'agencement d'amplificateurs de puissance (1100) comprend :

deux entrées (entrée F1, entrée F2), chaque entrée est destinée à recevoir un signal d'entrée dans une bande de fréquences des deux bandes de fréquences (F1, F2) ;

deux sorties (sortie F1, sortie F2), chaque sortie est destinée à fournir un signal de sortie dans une bande de fréquences des deux bandes de fréquences (F1, F2) ;

deux amplificateurs principaux (Principal 1, Principal 2), dans lequel les entrées des deux amplificateurs principaux sont couplées aux entrées respectives de l'agencement d'amplificateurs de puissance (1100) pour recevoir les signaux d'entrée dans les bandes de fréquences respectives et les sorties des deux amplificateurs principaux sont couplées aux sorties respectives de l'agencement d'amplificateurs de puissance (1100) pour fournir les signaux de sortie dans les bandes de fréquences respectives ;

quatre amplificateurs auxiliaires (Aux 1, Aux 2, Aux 3, Aux 4) ; et

six coupleurs hybrides (HC1, HC2, HC3, HC4, HC5, HC6), dans lequel 3 coupleurs hybrides (HC1, HC2, HC3) sont situés aux entrées et 3 coupleurs hybrides (HC4, HC5, HC6) sont situés aux sorties de l'agencement d'amplificateurs de puissance (1100) ; et dans lequel

les entrées des amplificateurs auxiliaires sont couplées aux entrées de l'agencement d'amplificateurs de puissance (1100) par l'intermédiaire des coupleurs hybrides d'entrée (HC1, HC2, HC3), les sorties des amplificateurs auxiliaires sont couplées aux sorties de l'agencement d'amplificateurs de puissance (1100) par l'intermédiaire des coupleurs hybrides de sortie (HC4, HC5, HC6).

14. Amplificateur de puissance multibande comprenant un ou plusieurs agencements d'amplificateurs de puissance (200, 300, 400, 700, 800, 900, 1000, 1100) selon l'une quelconque des revendications 1-13.

15. Appareil électronique comprenant un ou plusieurs agencements d'amplificateurs de puissance selon l'une quelconque des revendications 1-13.

16. Appareil électronique selon la revendication 15, dans lequel l'appareil électronique est l'un quelconque parmi un émetteur, un émetteur-récepteur, un dispositif de communication sans fil, une station de base radio, un nœud de réseau pour un système de communication cellulaire.

(a)

(b)

Fig. 1

200

F1 input

Single Band F1     Θ=90@f1     F1 output

Main 1

T1

Pin2:iso   Pin3     WideBand F1+F2

S1_90              Aux 1                    Pin2         Pin3   S1_90+0
                                                               S1_0+90

Wideband F1+F2

S1_0              Aux 2                              Pin4

Pin1        Pin4                          Pin1               S1_90+90
HC1                                       HC2                S1_0+0

Single Band F2     Θ=90@f2

Main 2

T2

F2 input                                                    F2 output

(a)

Fig. 2

Input Matching network
and phase offset

F1 input

Single Band F1

Main
1

Θ=90@f1

F1 output

Transmission line

Matching network

Input Matching network

WideBand F1+F2

Aux
1

Matching network

Matching network

Wideband F1+F2

Aux
2

Matching network

Hybrid
Coupler

Input Matching network

Hybrid
Coupler

Matching network

F2 input

Single Band F2

Main
2

Θ=90@f2

F2 output

Input Matching network
and phase offset

Transmission line

(b)

Fig. 2

25

300

F1 input

Single Band F1        Θ=90@f1        F1 output

Main 1

Isolation Circuit

WideBand F1+F2

Aux 1

Wideband F1+F2

Aux 2

HC1        HC2        Isolation Circuit

Single Band F2        Θ=90@f2

Main 2

F2 input

F2 output

(a)

90@F1 or F2

TL1

TL2

Parallel resonator
@ F2 or F1

(b)

(2n+1)*Quarter wavelength
open line n=0,1,2……

(c)

Series LC

(d)

Fig. 3

400

(a)

(b)

(c)

(d)

(e)

Fig. 4

Fig. 5

F1 input

Single Band F1    Θ=90@f1    F1 output

Main 1

Isolation Circuit

WideBand F1+F2

Aux 1

Wideband F1+F2

Aux 2

HC1

HC2

Isolation Circuit

Single Band F2    Θ=90@f2

Main 2

F2 input

F1 output

F2 output

Output power

main

Auxiliary

Th    Intput power

Fig. 6

Fig. 7

(a)

700

F1 input

offset 1

Single Band F1

Main 1

Θ=90@f1

T1

F1 output

offset 4

Short for F2

offset 3

offset 9

WideBand F1+F2

Aux 1

offset 7

offset 10

Wideband F1+F2

Aux 2

offset 8

HC1

HC2

offset 5

Short For F1

offset 6

F2 input

offset 2

Single Band F2

Main 2

T2

Θ=90@f2

F2 output

(b)

700

Fig. 7

EP 4 364 290 B1

800

Single Band F1

F1 input

Main 1

Θ=90@f1

F1 output

T1

S1

WideBand F1+F2

Aux 1

HC1

HC2

Wideband F1+F2

Aux 2

S2

Single Band F2

Main 2

T2

F2 input

Θ=90@f2

F2 output

Fig. 8

900

RX1

TOR 1

Variable attenuator

TX F1 input

Single Band F1

Main 1

Θ=90@f1

TX F1 output

WideBand F1+F2

Aux 1

Short for F2

Wideband F1+F2

Aux 2

HC1

HC2

Single Band F2

Main 2

Θ=90@f2

Short for F1

TX F2 input

TOR 2

Variable attenuator

RX2

TX F2 output

Fig. 9

1000

F1 input      Θ=90@f1     Single Band F1     Θ=90@f1     F1 output

Main 1

F2 input      Single Band F2     Θ=90@f2     F2 output

Main 2

WideBand F1+F2+F4

Pin2   Pin3   Aux 1   Pin2   Pin3

Pin1   Pin4   HC2

Wideband F1+F2+F4

Aux 2   Pin4

Pin1   HC4   Pin2   Pin3

Pin2   Pin3

Pin1   Pin4   HC1

Pin4   HC6

WideBand F1+F3+F4

Pin2   Pin3   Aux 3   Pin2

Pin1   Pin1   HC6

Pin1   Pin3

Wideband F1+F3+F4

Pin2   Pin3   Aux 4   Pin4

Pin1   HC3   Pin1   HC5

Single Band F3

F3 input   Main 3   Θ=90@f3   F3 output

Single Band F4

F4 input   Θ=90@f4   Main 4   Θ=90@f4   F4 output

Fig. 10

1100

Single Band F1

F1 input

Main 1

F1 output

Θ=90@f1    Θ=90@f1

WideBand

Pin2    Pin3    Aux 1    Pin2    Pin3

Wideband

Pin2    Pin1    Aux 2    Pin1    Pin4

Pin3    HC2    Pin4    HC4    Pin2    Pin3

Pin2    Pin3

Pin4    HC6

Pin1    HC1    Pin2    WideBand    Pin1    Pin4

Pin4    Aux 3    Pin2

Pin3    HC3    Pin3

Wideband

Pin1    HC3    Pin4    Aux 4    Pin1    Pin4

HC5

Single Band F2

F2 input

Main 2

F2 output

Θ=90@f2    Θ=90@f2

Fig. 11

Fig. 12

Fig. 13

m29
indep(m29)=41.408
vs(Efficiency_F1,Pfund_low)=74.107

Gain and Efficiency

Output Power_F1, dBm

## Fig. 14

m32
indep(m32)=41.484
vs(Efficiency_F1,Pfund_low)=69.820

Gain and Efficiency

Output Power, dBm

## Fig. 15

Fig. 16

m29
indep(m29)=41.731
vs(Efficiency_F1,Pfund_low)=77.490

Gain and Efficiency

Fig. 17

m32
indep(m32)=41.793
vs(Efficiency_F1,Pfund_low)=78.242

Gain and Efficiency

Fig. 18

40

Fig. 19

PA
100, 200, 300, 400,
700, 800, 900,
1000, 1100

Processing
unit
2030

Memory
2020

Electronic circuit/apparatus 2000

Fig. 20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2713505 A
- US 2013099866 A1
- US 9634615 B1

### Non-patent literature cited in the description

- **JINGZHOU PANG**. Novel design of highly-efficiency concurrent dual-band GaN Doherty power amplifier using direct-matching impedance transformers. *IEEE MTT-S International Microwave Symposium (IMS)*, 2016